# EUROPEAN PATENT SPECIFICATION

(11) **EP 4 425 558 B1**
(45) Date of publication and mention of the grant of the patent: **26.08.2026**
(21) Application number: 22886454.2
(22) Date of filing: 02.09.2022
(51) Int. Cl.: H10F 39/00, H10K 39/32, H10F 39/12

(54) **SOLID-STATE IMAGING DEVICE**
FESTKÖRPER-BILDAUFNAHMEVORRICHTUNG
DISPOSITIF D'IMAGERIE À SEMI-CONDUCTEURS

(30) Priority: 29.10.2021 JP 2021178002
(43) Date of publication of application: 04.09.2024
(73) Proprietor: Sony Semiconductor Solutions Corporation, Atsugi-shi, Kanagawa 243-0014 (JP)
(72) Inventor: IIJIMA, Tadashi, Atsugi-shi, Kanagawa 243-0014 (JP); SUZUKI, Ryosuke, Atsugi-shi, Kanagawa 243-0014 (JP); YAGI, Iwao, Atsugi-shi, Kanagawa 243-0014 (JP); JOEI, Masahiro, Atsugi-shi, Kanagawa 243-0014 (JP); MURATA, Kenichi, Atsugi-shi, Kanagawa 243-0014 (JP)
(74) Representative: Müller Hoffmann & Partner
(86) International application number: PCT/JP2022/033157
(87) International publication number: WO 2023/074120

(56) References cited:
- WO-A1-2020/026851
- JP-A- 2018 093 052
- JP-A- H02 128 468
- JP-A- H02 128 468
- JP-A- H03 185 762
- US-A1- 2016 190 211
- US-A1- 2020 035 746
- US-A1- 2021 273 017

## Description

### Technical Field

The present disclosure relates to solid-state imaging device.

### Background Art

PTL 1 discloses an imaging element and a solid-state imaging device. A pixel section of each of the imaging element and the solid-state imaging device includes a first electrode stacked on a semiconductor substrate, a photoelectric conversion film stacked on the first electrode, and a second electrode stacked on the photoelectric conversion film. In a peripheral region around the pixel section, a coupling section that supplies electricity to the pixel section is disposed on the semiconductor substrate.

A protective film is formed on the pixel section and the peripheral region. Further, a light-blocking film is formed on the protective film in the peripheral region. A metal wiring material that blocks light and has electrical conductivity is used for a light-blocking film.

### Citation List

### Patent Literature

Document US 2021/273017 A1 relates to an imaging element including: a semiconductor substrate having an effective pixel region in which a plurality of pixels is disposed and a peripheral region provided around the effective pixel region; an organic photoelectric converter including a first electrode, a second electrode, a charge accumulation layer, and an organic photoelectric conversion layer, the first electrode being provided on a light receiving surface of the semiconductor substrate and including a plurality of electrodes, the second electrode being opposed to the first electrode, the charge accumulation layer and the organic photoelectric conversion layer being stacked in this order between the first electrode and the second electrode and extending over the effective pixel region; and a first hydrogen-blocking layer that covers above the organic photoelectric conversion layer, a side surface of the organic photoelectric conversion layer, and a side surface of the charge accumulation layer. Document US 2016/190211 A1 provides a solid-state image pickup device that makes it possible to enhance image quality, and a manufacturing method thereof, and an electronic apparatus. The solid-state image pickup device includes a pixel section that includes a plurality of pixels, the pixels each including one or more organic photoelectric conversion sections, wherein the pixel section includes an effective pixel region and an optical black region, and the organic photoelectric conversion sections of the optical black region include a light-shielding film and a buffer film on a light-incidence side.
PTL 1: Japanese Unexamined Patent Application Publication No. 2017-157816

### Summary of the Invention

In each of an imaging element and a solid-state imaging device, a metal wiring material is used for a light-blocking section, thus enabling a light-blocking film to be used as a wiring line. The light-blocking film is usable, for example, as a wiring line that couples a second electrode of a pixel section and a coupling section of a peripheral region to each other. The wiring line extends to be provided on a protective film; one end of the wiring line is coupled to the second electrode through a coupling hole formed in the protective film, and the other end of the wiring line is coupled to the coupling section through the coupling hole.

However, the wiring line is routed to the coupling hole, the top of the protective film, and back to the coupling hole, thus causing a wiring structure to be complicated. In addition, the wiring line is routed, thus causing a wiring resistance to be increased.

It is therefore desired, for a solid-state imaging device, to have a simplified wiring structure and a reduced wiring resistance.

A solid-state imaging device according to the invention is defined in claim 1.

### Brief Description of the Drawings

[FIG. 1] FIG. 1 is an explanatory cross-sectional view of an overall schematic configuration of a solid-state imaging device according to a first embodiment of the present disclosure.
[FIG. 2] FIG. 2 is a schematic plan view of the solid-state imaging device illustrated in FIG. 1.
[FIG. 3] FIG. 3 is an explanatory first process cross-sectional view of a manufacturing method of the solid-state imaging device illustrated in FIG. 1.
[FIG. 4] FIG. 4 is a second process cross-sectional view.
[FIG. 5] FIG. 5 is a third process cross-sectional view.
[FIG. 6] FIG. 6 is a fourth process cross-sectional view.
[FIG. 7] FIG. 7 is a fifth process cross-sectional view.
[FIG. 8] FIG. 8 is a sixth process cross-sectional view.
[FIG. 9] FIG. 9 is a seventh process cross-sectional view.
[FIG. 10] FIG. 10 is an eighth process cross-sectional view.
[FIG. 11] FIG. 11 is a ninth process cross-sectional view.
[FIG. 12] FIG. 12 is a tenth process cross-sectional view.
[FIG. 13] FIG. 13 is an eleventh process cross-sectional view.
[FIG. 14] FIG. 14 is a twelfth process cross-sectional view.
[FIG. 15] FIG.15 is an explanatory cross-sectional view corresponding to FIG. 1 of an overall schematic configuration of a solid-state imaging device according to a second embodiment of the present disclosure.
[FIG. 16] FIG. 16 is an explanatory first process cross-sectional view of a manufacturing method of the solid-state imaging device illustrated in FIG. 15.
[FIG. 17] FIG. 17 is a second process cross-sectional view.
[FIG. 18] FIG. 18 is a third process cross-sectional view.
[FIG. 19] FIG. 19 is a fourth process cross-sectional view.
[FIG. 20] FIG. 20 is a fifth process cross-sectional view.
[FIG. 21] FIG. 21 is a sixth process cross-sectional view.
[FIG. 22] FIG. 22 is a seventh process cross-sectional view.
[FIG. 23] FIG. 23 is an eighth process cross-sectional view.
[FIG. 24] FIG. 24 is a ninth process cross-sectional view.
[FIG. 25] FIG. 25 is an explanatory cross-sectional view corresponding to FIG. 1 of an overall schematic configuration of a solid-state imaging device according to a third embodiment of the present disclosure.
[FIG. 26] FIG. 26 is an explanatory first process cross-sectional view of a manufacturing method of the solid-state imaging device illustrated in FIG. 25.
[FIG. 27] FIG. 27 is a second process cross-sectional view.
[FIG. 28] FIG. 28 is a third process cross-sectional view.
[FIG. 29] FIG. 29 is a fourth process cross-sectional view.
[FIG. 30] FIG. 30 is a fifth process cross-sectional view.
[FIG. 31] FIG. 31 is a sixth process cross-sectional view.
[FIG. 32] FIG. 32 is a seventh process cross-sectional view.
[FIG. 33] FIG. 33 is an eighth process cross-sectional view.
[FIG. 34] FIG. 34 is a ninth process cross-sectional view.
[FIG. 35] FIG. 35 is an explanatory cross-sectional view corresponding to FIG. 1 of an overall schematic configuration of a solid-state imaging device according to a fourth embodiment of the present disclosure.
[FIG. 36] FIG. 36 is an explanatory first process cross-sectional view of a manufacturing method of the solid-state imaging device illustrated in FIG. 35.
[FIG. 37] FIG. 37 is a second process cross-sectional view.
[FIG. 38] FIG. 38 is a third process cross-sectional view.
[FIG. 39] FIG. 39 is a fourth process cross-sectional view.
[FIG. 40] FIG. 40 is a fifth process cross-sectional view.
[FIG. 41] FIG. 41 is a sixth process cross-sectional view.
[FIG. 42] FIG. 42 is an explanatory cross-sectional view corresponding to FIG. 1 of an overall schematic configuration of a solid-state imaging device according to a fifth embodiment of the present disclosure.
[FIG. 43] FIG. 43 is an explanatory first process cross-sectional view of a manufacturing method of the solid-state imaging device illustrated in FIG. 42.
[FIG. 44] FIG. 44 is a second process cross-sectional view.
[FIG. 45] FIG. 45 is a third process cross-sectional view.
[FIG. 46] FIG. 46 is a fourth process cross-sectional view.
[FIG. 47] FIG. 47 is a fifth process cross-sectional view.
[FIG. 48] FIG. 48 is an explanatory first process cross-sectional view of a manufacturing method of a solid-state imaging device according to a sixth embodiment of the present disclosure.
[FIG. 49] FIG. 49 is a second process cross-sectional view.
[FIG. 50] FIG. 50 is an explanatory cross-sectional view corresponding to FIG. 1 of an overall schematic configuration of a solid-state imaging device according to a seventh embodiment of the present disclosure.
[FIG. 51] FIG. 51 is an explanatory first process cross-sectional view of a manufacturing method of the solid-state imaging device illustrated in FIG. 50.
[FIG. 52] FIG. 52 is a second process cross-sectional view.
[FIG. 53] FIG. 53 is a third process cross-sectional view.
[FIG. 54] FIG. 54 is a fourth process cross-sectional view.
[FIG. 55] FIG. 55 is an explanatory first process cross-sectional view of a manufacturing method of a solid-state imaging device according to an eighth embodiment of the present disclosure.
[FIG. 56] FIG. 56 is a second process cross-sectional view.
[FIG. 57] FIG. 57 is an explanatory cross-sectional view corresponding to FIG. 1 of an overall schematic configuration of a solid-state imaging device according to a ninth embodiment of the present disclosure.
[FIG. 58] FIG. 58 is an explanatory first process cross-sectional view of a manufacturing method of the solid-state imaging device illustrated in FIG. 57.
[FIG. 59] FIG. 59 is a second process cross-sectional view.
[FIG. 60] FIG. 60 is a third process cross-sectional view.
[FIG. 61] FIG. 61 is a fourth process cross-sectional view.
[FIG. 62] FIG. 62 is a fifth process cross-sectional view.
[FIG. 63] FIG. 63 is an explanatory cross-sectional view of an overall schematic configuration of a solid-state imaging device according to a tenth embodiment of the present disclosure.
[FIG. 64] FIG. 64 is a schematic plan view of the solid-state imaging device illustrated in FIG. 63.
[FIG. 65] FIG. 65 is an explanatory first process cross-sectional view of a manufacturing method of the solid-state imaging device the illustrated in FIG. 62.
[FIG. 66] FIG. 66 is a second process cross-sectional view.
[FIG. 67] FIG. 67 is a third process cross-sectional view.
[FIG. 68] FIG. 68 is a fourth process cross-sectional view.
[FIG. 69] FIG. 69 is a fifth process cross-sectional view.
[FIG. 70] FIG. 70 is a sixth process cross-sectional view.
[FIG. 71] FIG. 71 is a seventh process cross-sectional view.
[FIG. 72] FIG. 72 is an eighth process cross-sectional view.
[FIG. 73] FIG. 73 is a ninth process cross-sectional view.
[FIG. 74] FIG. 74 is an explanatory cross-sectional view of a configuration of a modeled pixel section of a solid-state imaging device according to an eleventh embodiment of the present disclosure.
[FIG. 75] FIG. 75 is a cross-sectional view corresponding to FIG. 74 of a solid-state imaging device according to a twelfth embodiment of the present disclosure.
[FIG. 76] FIG. 76 is a cross-sectional view corresponding to FIG. 74 of a solid-state imaging device according to a thirteenth embodiment of the present disclosure.
[FIG. 77] FIG. 77 is a cross-sectional view corresponding to FIG. 74 of a solid-state imaging device according to a fourteenth embodiment of the present disclosure.
[FIG. 78] FIG. 78 is a cross-sectional view corresponding to FIG. 74 of a solid-state imaging device according to a fifteenth embodiment of the present disclosure.

### Modes for Carrying Out the Invention

Hereinafter, description is given in detail of an embodiment of the present disclosure with reference to the drawings. It is to be noted that the description is given in the following order.

### 1. First Embodiment

A first embodiment describes an example in which the present technology is applied to a solid-state imaging device. The first embodiment describes, in detail, a cross-sectional configuration, a planar configuration, and a manufacturing method of the solid-state imaging device.

### 2. Second Embodiment

A second embodiment describes an example in which structures of a side surface of a pixel section and a peripheral region are changed in the solid-state imaging device according to the first embodiment. The second embodiment also describes, in detail, a cross-sectional configuration and a manufacturing method of the solid-state imaging device.

### 3. Third Embodiment

A third embodiment describes an example in which the structure of the side surface of the pixel section is changed in the solid-state imaging device according to the first embodiment. The third embodiment also describes, in detail, a cross-sectional configuration and a manufacturing method of the solid-state imaging device.

### 4. Fourth Embodiment

A fourth embodiment describes an example in which the structure of the side surface of the pixel section is changed in the solid-state imaging device according to the third embodiment. The fourth embodiment also describes, in detail, a cross-sectional configuration and a manufacturing method of the solid-state imaging device.

### 5. Fifth Embodiment

A fifth embodiment describes an example in which the structure of the side surface of the pixel section, in particular, a structure of a sidewall insulator is changed in the solid-state imaging device according to the first embodiment. The fifth embodiment also describes, in detail, a cross-sectional configuration and a manufacturing method of the solid-state imaging device.

### 6. Sixth Embodiment

A sixth embodiment describes an example in which a manufacturing method of the sidewall insulator of the solid-state imaging device according to the fifth embodiment is changed in the solid-state imaging device according to the fifth embodiment.

### 7. Seventh Embodiment

A seventh embodiment describes an example in which structures of a transparent electrode of the pixel section and a wiring line coupling the transparent electrode and a coupling section in the peripheral region are changed in the solid-state imaging device according to the fifth embodiment. The seventh embodiment also describes, in detail, a cross-sectional configuration and a manufacturing method of the solid-state imaging device.

### 8. Eighth Embodiment

An eighth embodiment describes an example in which the manufacturing method of the sidewall insulator is changed in the solid-state imaging device according to the sixth embodiment.

### 9. Ninth Embodiment

A ninth embodiment describes an example in which a structure of the coupling section in the peripheral region is changed in the solid-state imaging device according to the fifth embodiment. The ninth embodiment also describes, in detail, a cross-sectional configuration and a manufacturing method of the solid-state imaging device.

### 10. Tenth embodiment

A tenth embodiment describes an example in which structures of a protective film of the pixel section and the peripheral region and the light-blocking film in the peripheral region are changed in the solid-state imaging device according to the first embodiment. The tenth embodiment also describes, in detail, a cross-sectional configuration and a manufacturing method of the solid-state imaging device.

### 11. Eleventh Embodiment

An eleventh embodiment is an explanatory first example of a structure of a solid-state imaging device to which the present technology is applicable. The eleventh embodiment briefly describes a schematic cross-sectional configuration of a main part of the solid-state imaging device. The same also applies to solid-state imaging devices according to twelfth to fifteenth embodiments.

### 12. Twelfth Embodiment

A twelfth embodiment is an explanatory second example of the structure of the solid-state imaging device to which the present technology is applicable.

### 13. Thirteenth Embodiment

A thirteenth embodiment is an explanatory third example of the structure of the solid-state imaging device to which the present technology is applicable.

### 14. Fourteenth Embodiment

The fourteenth embodiment is an explanatory fourth example of the structure of the solid-state imaging device to which the present technology is applicable.

### 15. Fifteenth Embodiment

The fifteenth embodiment is an explanatory fifth example of the structure of the solid-state imaging device to which the present technology is applicable.

### 16. Other Embodiments

### <1. First Embodiment>

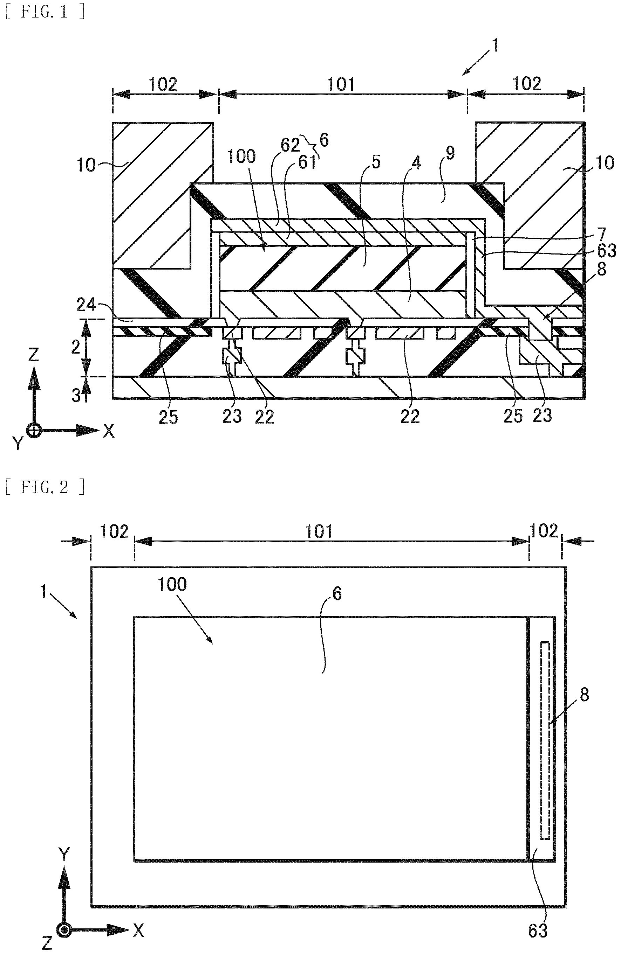

Description is given of a solid-state imaging device 1 according to a first embodiment of the present disclosure with reference to FIGs. 1 to 14.

Here, an arrow-X direction illustrated as appropriate in the drawings indicates one planar direction of the solid-state imaging device 1 placed on a plane for convenience. An arrow-Y direction indicates another planar direction orthogonal to the arrow-X direction. In addition, an arrow-Z direction indicates an upward direction orthogonal to the arrow-X direction and the arrow-Y direction. That is, the arrow-X direction, the arrow-Y direction, and the arrow-Z direction exactly coincide with an X-axis direction, a Y-axis direction, and a Z-axis direction, respectively, of a three-dimensional coordinate system.

It is to be noted that these directions are each illustrated to aid understanding of descriptions, and are not intended to limit directions used in the present technology.

### [Configuration of Solid-State Imaging Device 1]

### (1) Overall Configuration of Solid-State Imaging Device 1

FIG. 1 illustrates an example of a longitudinal cross-sectional configuration of the solid-state imaging device 1. FIG. 2 illustrates an example of a planar configuration of the solid-state imaging device 1.

The solid-state imaging device 1 includes an effective pixel region 101 including a pixel section 100 at a middle part on an insulator 2, as viewed in the arrow-Y direction (hereinafter, simply referred to as "in a side view") and as viewed in the arrow-Z direction (hereinafter, simply referred to as "in a plan view"). Further, the solid-state imaging device 1 includes a peripheral region 102 around the effective pixel region 101 on the insulator 2.

Here, the effective pixel region 101 is formed in a rectangular shape in which a length of the arrow-Y direction is shorter than a length of the arrow-X direction, in a plan view, although the shape thereof is not particularly limited. In addition, as for the overall planar shape, the solid-state imaging device 1 is formed in a rectangular shape one size larger than the effective pixel region 101, with the peripheral region 102 being added around the effective pixel region 101.

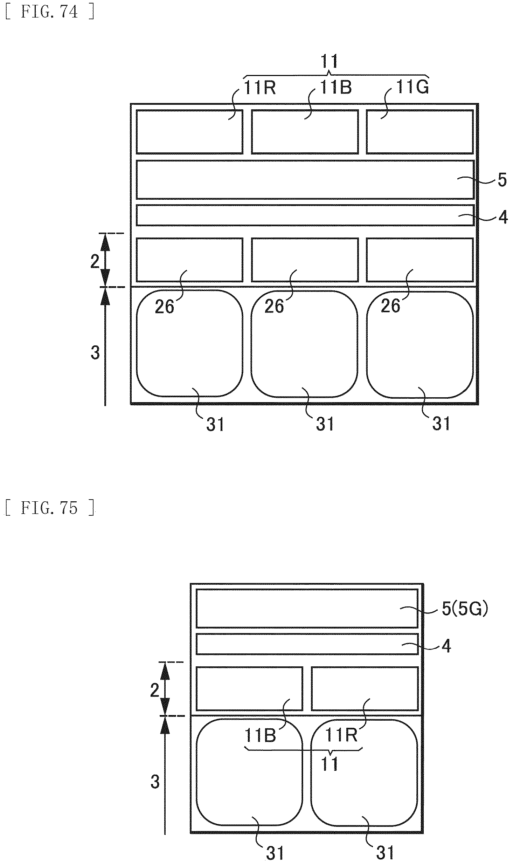

The insulator 2 is stacked on a base body 3. The insulator 2 coats a multilayer-structured wiring line, a coupling hole wiring line, or the like, and has an insulation property and an environmental tolerance, although a detailed description of the structure is omitted. In addition, an unillustrated visible light transmission filter is disposed inside the insulator 2, and the insulator 2 coats and protects the visible light transmission filter. As the visible light transmission filter, for example, an infrared transmission filter (IRPF) is used (see reference numeral 26 illustrated in FIG. 74).

In addition, for example, silicon oxide (e.g., SiO) is used as the insulator 2. In addition, a wiring line 22 is disposed inside the insulator 2 in a light transmission region. A transparent electrode material is used for the wiring line 22. For example, indium-tin oxide (ITO: Indium Tin Oxide) is used as the transparent electrode material. In addition, a wiring line 23 is disposed between the wiring line 22 and the base body 3 to electrically couple them to each other. For example, a metal wiring line of tungsten (W) or the like is used as the wiring line 23.

Meanwhile, an insulating film 24 is formed as an uppermost layer of the insulator 2. The insulating film 24 is formed by SiOx, for example. In addition, an insulating film 25 is formed below the insulating film 24 in the peripheral region 102. The insulating film 25 is formed by silicon nitride (SiN), for example.

The base body 3 is configured by alternately stacking multiple semiconductor layers and an insulating layer in which a multilayered wiring line is disposed, although a detailed description of the structure is omitted.

For example, a photodiode (Photo Diode) is configured in semiconductor layers stacked closest to a side of the insulator 2 (see, e.g., reference numeral 31 illustrated in FIG. 74). Multiple photodiodes are arranged at certain intervals in the arrow-X direction and the arrow-Y direction. The photodiode is configured as a photodetection element.

Further, a photodetection circuit, a control circuit, or the like is disposed, for example, in a semiconductor layer spaced apart from the insulator 2, with the semiconductor layer configured by the photodiodes being interposed therebetween. In the photodetection circuit, a photodetection signal from the photodiode is read. The control circuit serves to control an operation of the pixel section 100, the photodetection circuit, or the like.

### (2) Configuration of Effective Pixel Region 101

The pixel section 100 disposed in the effective pixel region 101 includes a transparent semiconductor 4, an organic photoelectric conversion film 5, and a transparent electrode 6 as main components.

The transparent semiconductor 4 is stacked on the insulator 2. In the transparent semiconductor 4, electrons converted from light at the organic photoelectric conversion film 5 are accumulated. Further, the transparent semiconductor 4 is coupled to the light detection element disposed in the base body 3 described above through an unillustrated multilayered wiring line formed inside the insulator 2, and the accumulated electrons are transferred to the light detection element.

The transparent semiconductor 4 is an oxide semiconductor that transmits an electromagnetic wave in a visible light range. As the transparent semiconductor 4, for example, IGZO containing indium (In), gallium (Ga), zinc (Zn), or oxygen (O) is used. The transparent semiconductor 4 is formed to have a thickness of 1 nm or more and 10000 nm or less, for example.

The organic photoelectric conversion film 5 is stacked on the transparent semiconductor 4. In the organic photoelectric conversion film 5, electrons are generated from light incident in the arrow-Z direction.

As for the organic photoelectric conversion film 5, an organic material is used as a light-receiving element material. It is sufficient to adopt, as the organic material, an organic film that allows for photoelectric conversion. The organic photoelectric conversion film 5 is formed to have a thickness of 1 nm or more and 100 µm or less, for example.

The transparent electrode 6 is stacked on the organic photoelectric conversion film 5. The transparent electrode 6 is configured as an electrode common to the entire region of the pixel section 100, and the transparent electrode 6 is supplied with electricity to be applied to the entire region of the organic photoelectric conversion film 5.

In the first embodiment, the transparent electrode 6 includes a first transparent electrode 61 and a second transparent electrode 62 stacked on the first transparent electrode 61 on a side opposite to the organic photoelectric conversion film 5.

The first transparent electrode 61, in this example, is formed by indium oxide-zinc oxide-based oxide (IZO). The first transparent electrode 61 is formed to have a thickness of 1 nm or more and 1000 nm or less, for example. As for the thickness, the first transparent electrode 61 is formed to be thinner in thickness than the second transparent electrode 62. This makes it possible to easily perform working in manufacturing the first transparent electrode 61.

The second transparent electrode 62, in this example, is formed by the same transparent electrode material as that of the first transparent electrode 61. The second transparent electrode 62 is formed to have a thickness of 1 nm or more and 1000 nm or less, for example. As for the thickness, the second transparent electrode 62 is formed to be thicker in thickness than the first transparent electrode 61. This allows a thickness of the transparent electrode 6 including the first transparent electrode 61 and the second transparent electrode 62 to be increased, thus making it possible to reduce a resistance value of the transparent electrode 6. In addition, the second transparent electrode 62 is utilized for a wiring line 63, thus making it also possible to reduce a resistance value of the wiring line 63.

In addition, the transparent electrode 6 may be formed by a transparent electrode material other than IZO. For example, the transparent electrode 6 may be formed using one or more transparent electrode materials selected from ITO, tin oxide (SnOx), zinc oxide (ZnOx), titanium oxide (TiOx), and silver (Ag) nanowires. Further, in the transparent electrode 6, the second transparent electrode 62 may be formed by a transparent electrode material different from a transparent electrode material of the first transparent electrode 61. Detailed description is given of this specific exemplification in the solid-state imaging device 1 according to a seventh embodiment described later.

In the effective pixel region 101, a protective film 9 covering the transparent electrode 6 is formed on the transparent electrode 6. The protective film 9 is formed by, for example, aluminum oxide (AlO) having an insulation property and having an environmental tolerance. The protective film 9 is formed to have a thickness of 1 nm or more and 1000 nm or less, for example.

In the effective pixel region 101, a color filter and an optical lens, which are unillustrated, are each sequentially stacked on the protective film 9. The color filter is formed by, for example, a resin material to which respective dyes of red, blue, and green are added, which are three primary colors of light. The optical lens is formed by a resin material curved in the arrow-Z direction, for example.

### (3) Configuration of Peripheral Region 102

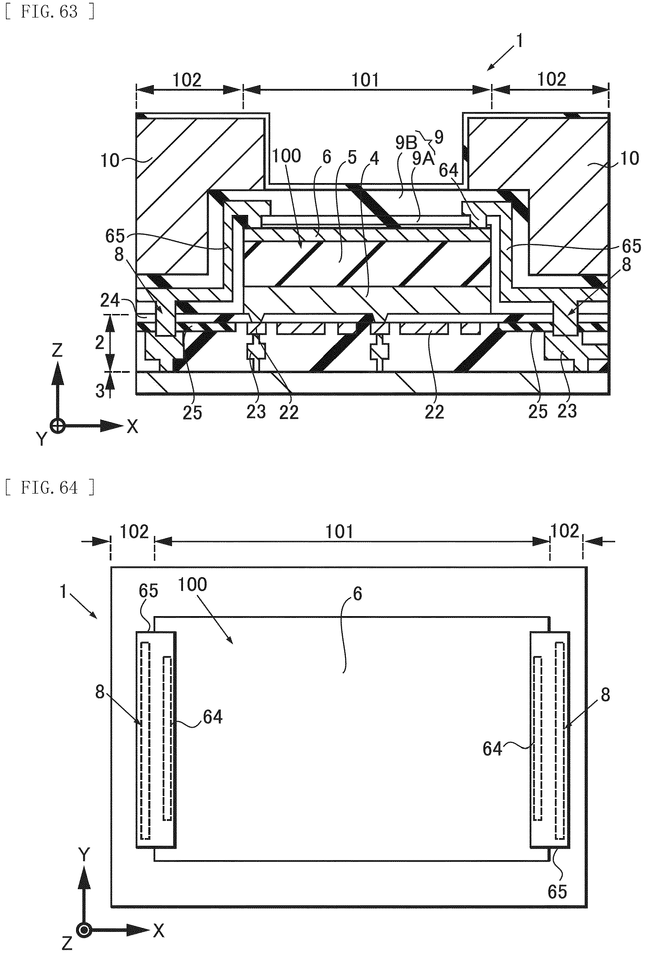

A coupling section 8 is disposed on the insulator 2 in the peripheral region 102. Here, the coupling section 8 is disposed on the right side of the effective pixel region 101 in a side view illustrated in FIG. 1 and in a plan view illustrated in FIG. 2. It is to be noted that the coupling section 8 may be disposed on the left side of the effective pixel region 101, or may be disposed on the upper or the lower side of the effective pixel region 101 in a plan view. In addition, the coupling section 8 is not limited to one location, but may be disposed on multiple locations on the right side and the left side of the effective pixel region 101, for example. As for the solid-state imaging device 1 according to a tenth embodiment described later, description is given of an example in which the coupling section 8 is disposed in multiple locations (see FIG. 64).

The coupling section 8 is coupled to the transparent electrode 6 of the pixel section 100 through the wiring line 63. That is, the coupling section 8 is coupled to an unillustrated circuit disposed in the base body 3 to supply electricity from this circuit to the transparent electrode 6 through the wiring line 63. The circuit may be the control circuit as described above or may be a power supply circuit.

In the first embodiment, the wiring line 63 is formed by the same transparent electrode material as that of the second transparent electrode 62 of the transparent electrode 6. Further, the wiring line 63 is formed by the same electrically-conductive layer as that of the second transparent electrode 62. That is, the second transparent electrode 62 constructs the transparent electrode 6 of the pixel section 100 in the effective pixel region 101, and is extended from the effective pixel region 101 to the peripheral region 102 to be formed as the wiring line 63. The wiring line 63 is then coupled to the multilayered wiring line 23 formed inside the insulator 2 to constitute the coupling section 8.

The wiring line 63 is formed using the second transparent electrode 62 which is a portion of the transparent electrode 6, and thus, as for the thickness, the wiring line 63 is formed to be thinner in thickness than the transparent electrode 6.

The wiring line 63, in this example, extends, on the right side of the effective pixel region 101, in a vertical direction (toward a side opposite to the arrow-Z direction) along a side surface of the pixel section 100 from a location of coupling to the transparent electrode 6. The wiring line 63 then extends in a horizontal direction (arrow-X direction) in the peripheral region 102. That is, the wiring line 63 couples the transparent electrode 6 and the coupling section 8 to each other at the shortest distance without being routed on the protective film 9, for example.

Here, a sidewall insulator 7 is formed between the side surface of the pixel section 100 and the wiring line 63, as illustrated in FIG. 1. The sidewall insulator 7 is formed by, for example, AlO having an insulation property and having an environmental tolerance, for example. The sidewall insulator 7 is formed to have a thickness of 1 nm or more and 1000 nm or less, for example, from the side surface of the pixel section 100 toward the peripheral region 102.

The protective film 9 covering the wiring line 63 is formed on the wiring line 63 in the peripheral region 102. The protective film 9 is formed by the same material as that of the protective film 9 on the effective pixel region 101, and is formed in the same layer.

Further, a light-blocking film 10 is formed on the protective film 9 in the peripheral region 102. The light-blocking film 10 is formed by a material that does not transmit light. Here, the light-blocking film 10 is formed by, for example, a metal material such as tungsten (W) or a resin material colored in black (e.g., a black resist).

In a case of the metal material, the light-blocking film 10 is formed to have a thickness of 1 nm or more and 1000 µm or less, for example. In addition, in a case of the resin material, the light-blocking film 10 is formed to have a thickness of 1 nm or more and 1000 µm or less, for example.

### [Manufacturing Method of Solid-State Imaging Device 1]

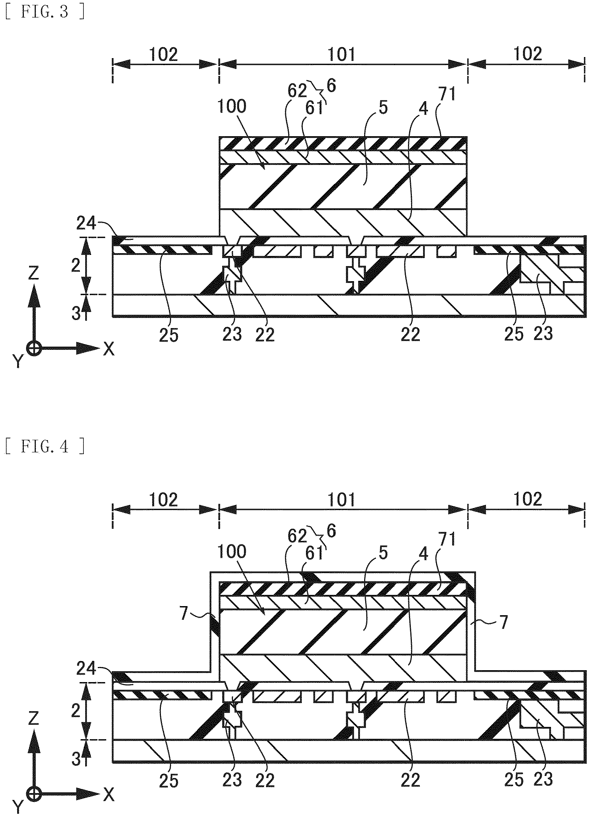

Next, description is given of a manufacturing method of the solid-state imaging device 1 with reference to FIGs. 3 to 14 while referring to FIGs. 1 and 2.

First, as illustrated in FIG. 3, in the effective pixel region 101, the transparent semiconductor 4, the organic photoelectric conversion film 5, the first transparent electrode 61 of the transparent electrode 6, and a mask 71 are each sequentially formed on the insulator 2. The first transparent electrode 61, the organic photoelectric conversion film 5, and the transparent semiconductor 4 are each patterned using the mask 71 of the uppermost layer. As the mask 71, for example, amorphous carbon is used.

As illustrated in FIG. 4, the sidewall insulator 7 is formed on the entire surface including the top of the mask 71 in the effective pixel region 101 and the top of the insulator 2 in the peripheral region 102. The sidewall insulator 7 is also formed on the side surface of the pixel section 100 at a boundary region between the effective pixel region 101 and the peripheral region 102. That is, the sidewall insulator 7 is formed along a side surface of the transparent semiconductor 4, a side surface of the organic photoelectric conversion film 5, and a side surface of the first transparent electrode 61. The sidewall insulator 7 is formed by AlO, for example. The sidewall insulator 7 is formed by an atomic layer deposition (ALD: Atomic Layer Deposition) method, for example.

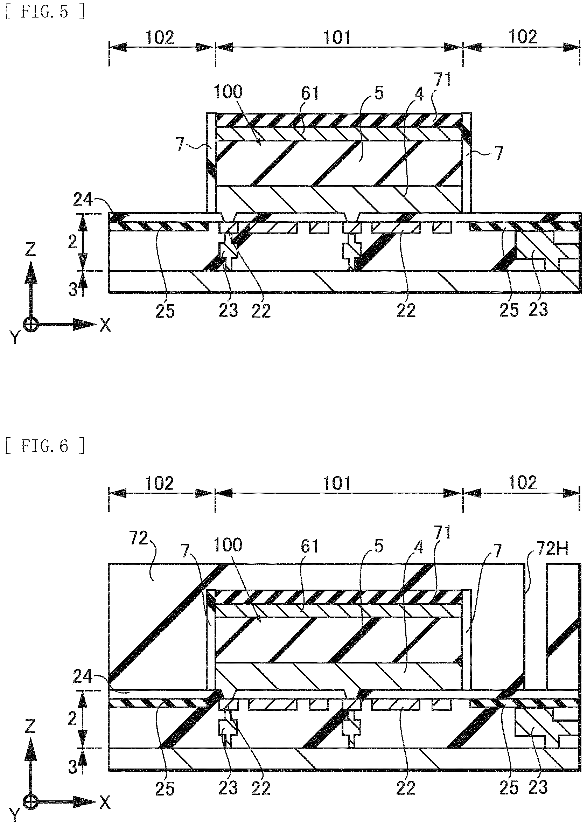

As illustrated in FIG. 5, the sidewall insulator 7 on the mask 71 in the effective pixel region 101 and the sidewall insulator 7 on the insulator 2 in the peripheral region 102 are removed, and the sidewall insulator 7 is formed on the side surface of the pixel section 100. To remove the sidewall insulator 7, for example, an anisotropic etching method such as a reactive ion etching (RIE: Reactive Ion Etching) method is used.

As illustrated in FIG. 6, a mask 72 is formed on the entire surfaces of the effective pixel region 101 and the peripheral region 102. The mask 72 is formed on the mask 71 in the effective pixel region 101, and is formed on the insulator 2 in the peripheral region 102. In the location of the coupling section 8 (see FIGs. 1 and 2) in the peripheral region 102, an opening 72H is formed in the mask 72. The mask 72 is formed by a photoresist, for example.

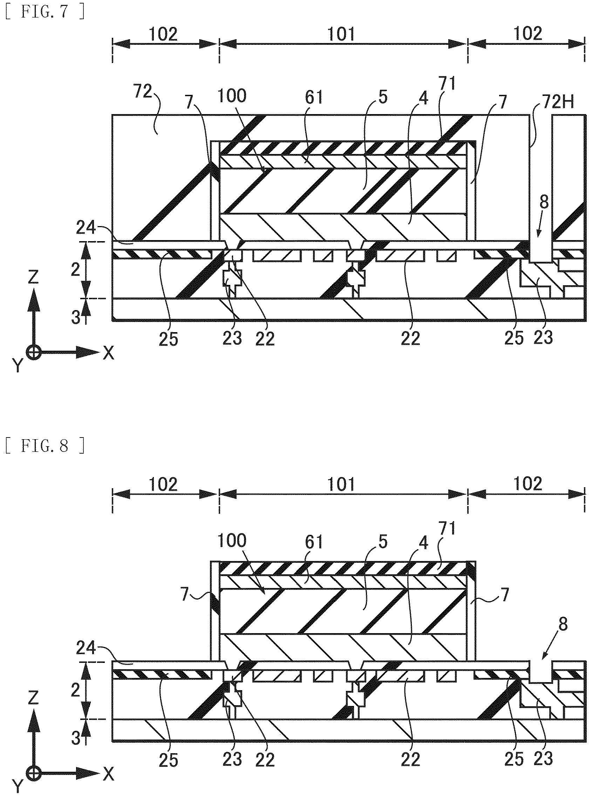

As illustrated in FIG. 7, the insulator 2 exposed from the opening 72H of the mask 72 is removed to allow a surface of the wiring line 23 inside the insulator 2 to be exposed. To remove the insulator 2, for example, the RIE method is used.

Thereafter, the mask 72 is removed as illustrated in FIG. 8.

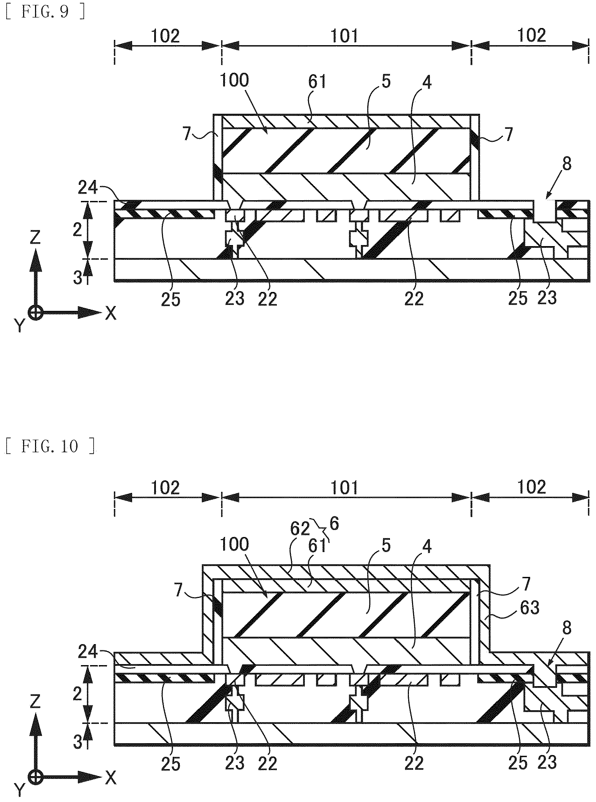

As illustrated in FIG. 9, in the effective pixel region 101, the mask 71 on the first transparent electrode 61 is removed. When the mask 71 is removed, a surface of the first transparent electrode 61 is exposed.

As illustrated in FIG. 10, the second transparent electrode 62 is formed on the entire surface including the top of the first transparent electrode 61 in the effective pixel region 101 and the top of the insulator 2 in the peripheral region 102. The second transparent electrode 62 is stacked on the first transparent electrode 61 in the effective pixel region 101, thus allowing for formation of the transparent electrode 6 including the first transparent electrode 61 and the second transparent electrode 62.

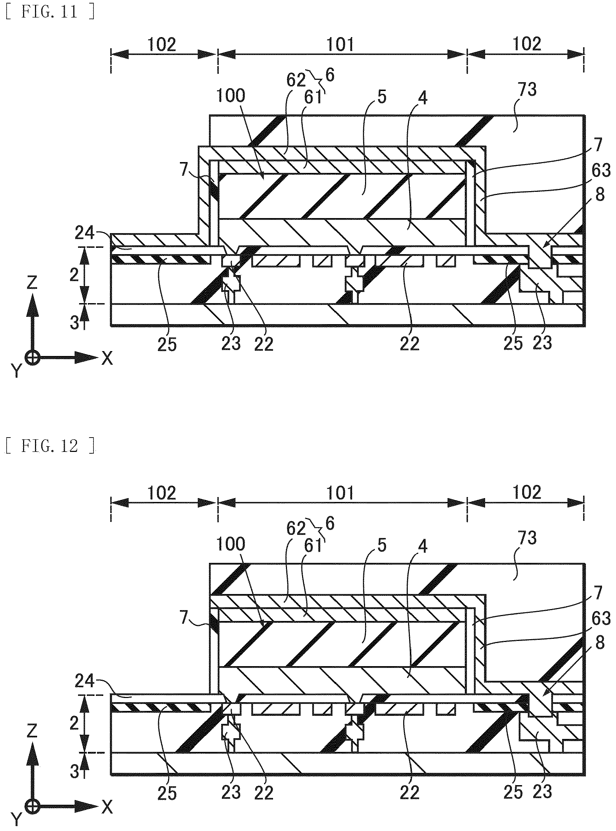

As illustrated in FIG. 11, a mask 73 is formed that covers the top of the transparent electrode 6 in the effective pixel region 101 and a location from the top of the transparent electrode 6 to the top of the coupling section 8. The mask 73 is formed by a photoresist, for example.

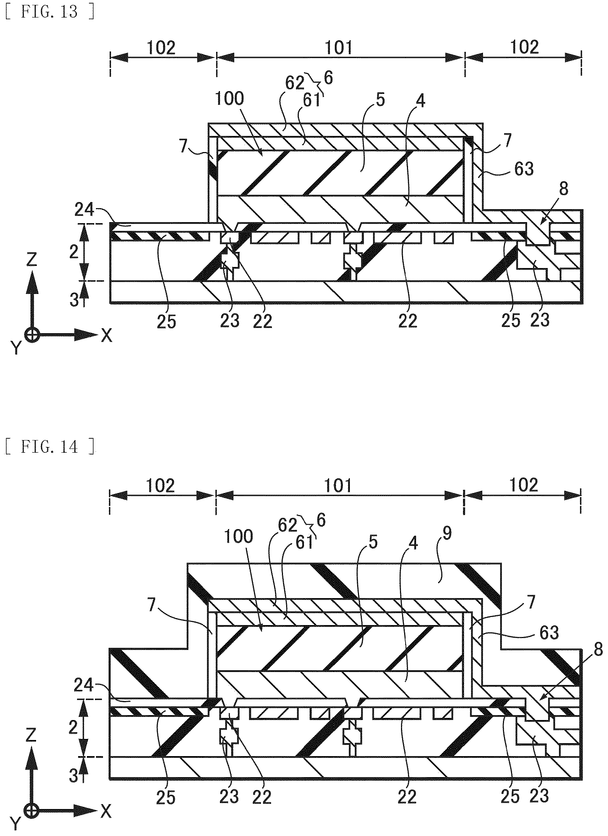

As illustrated in FIG. 12, the extra second transparent electrode 62 in the peripheral region 102 is removed using the mask 73. Subsequently, the mask 73 is removed as illustrated in FIG. 13.

This allows for formation of the wiring line 63 that is formed integrally with the second transparent electrode 62 of the transparent electrode 6, that is formed by the same transparent electrode material as that of the second transparent electrode 62, and that includes the same electrically-conductive layer as that of the second transparent electrode 62. The wiring line 63 is coupled to the wiring line 23 at the coupling section 8. In addition, in the pixel section 100, the wiring line 63 is electrically separated from the side surface of the transparent semiconductor 4, the side surface of the organic photoelectric conversion film 5, and the side surface of the first transparent electrode 61 of the transparent electrode 6, with the sidewall insulator 7 interposed therebetween.

As illustrated in FIG. 14, the protective film 9 is formed on the entire surface including the top of the transparent electrode 6 in the effective pixel region 101, the top of the wiring line 63 in the peripheral region 102, and the top of the coupling section 8 in the peripheral region 102. Subsequently, the light-blocking film 10 is formed on the protective film 9 in the peripheral region 102, as illustrated in FIG. 1 mentioned above.

When the series of manufacturing process ends, the solid-state imaging device 1 according to the first embodiment is completed.

### [Workings and Effects]

As illustrated in FIGs. 1 and 2, the solid-state imaging device 1 according to the first embodiment includes the pixel section 100 including the transparent semiconductor 4, the organic photoelectric conversion film 5 and the transparent electrode 6, the coupling section 8, and the wiring line 63.

The transparent semiconductor 4 is formed in the effective pixel region 101 of the insulator 2. The organic photoelectric conversion film 5 is formed on the transparent semiconductor 4 on a side opposite to the insulator 2. The transparent electrode 6 is formed on the organic photoelectric conversion film 5 on a side opposite to the transparent semiconductor 4. The coupling section 8 is disposed in the insulator 2 in the peripheral region 102 around the effective pixel region 101, and is coupled to a circuit that supplies electricity to the transparent electrode 6.

Here, the wiring line 63 electrically couples the transparent electrode 6 and the coupling section 8 to each other, and is formed by a transparent electrode material. Therefore, the wiring line 63 is formed by extending at least a portion of the transparent electrode 6, thus enabling the wiring line 63 to directly couple the transparent electrode 6 and the coupling section 8 to each other. That is, there is no need to form a coupling hole in the protective film 9 on the transparent electrode 6 and in the protective film 9 on the coupling section 8, and there is no need to route a wiring line in the coupling hole and on the protective film 9. This simplifies a wiring structure for coupling the transparent electrode 6 and the coupling section 8 to each other.

In addition, the wiring line 63 is not routed, and thus a wiring line length of the wiring line 63 is shortened, thus making it possible to reduce a wiring resistance of the wiring line 63.

In addition, in the solid-state imaging device 1, the wiring line 63 is formed to have a thickness thinner than the thickness of the transparent electrode 6, as illustrated in FIG. 1. In other words, as for the thickness, the transparent electrode 6 is formed to be thicker in thickness than the wiring line 63. It is therefore possible, in the effective pixel region 101, to reduce the resistance value of the transparent electrode 6 of the pixel section 100, thus making it possible to achieve uniform photoelectric conversion across the entire region of the pixel section 100.

Meanwhile, the wiring line 63 is formed to have a thin thickness, thus making it possible to easily perform working of the second transparent electrode 62 in the manufacturing method of the solid-state imaging device 1, as illustrated in FIGs. 11 and 12.

In addition, in the solid-state imaging device 1, the transparent electrode 6 includes the first transparent electrode 61 and the second transparent electrode 62, as illustrated in FIG. 1. The first transparent electrode 61 is formed on the organic photoelectric conversion film 5. The second transparent electrode 62 is formed on the first transparent electrode 61 on a side opposite to the organic photoelectric conversion film 5.

Accordingly, the transparent electrode 6 is formed to be thick by overlapping the first transparent electrode 61 and the second transparent electrode 62, thus making it possible to reduce the resistance value of the transparent electrode 6.

In addition, in the solid-state imaging device 1, the wiring line 63 is formed in the same electrically-conductive layer as that of at least a portion of the transparent electrode 6, as illustrated in FIG. 1. Specifically, the wiring line 63 is formed in the same electrically-conductive layer as that of the second transparent electrode 62 of the transparent electrode 6.

This makes it possible to simplify the wiring structure and thus to reduce the wiring resistance of the wiring line 63, as described above.

In addition, the solid-state imaging device 1 includes the sidewall insulator 7, as illustrated in FIG. 1. The sidewall insulator 7 is formed on the side surface of the organic photoelectric conversion film 5 and the side surface of the transparent semiconductor 4. Further, the wiring line 63 extends from the transparent electrode 6 to the coupling section 8 along the side surface of the organic photoelectric conversion film 5 and the side surface of the transparent semiconductor 4, with the sidewall insulator 7 interposed therebetween.

Thus, the wiring line 63 is electrically separated surely by the sidewall insulator 7 from the pixel section 100, specifically from each of the organic photoelectric conversion film 5 and the transparent semiconductor 4. Additionally, it is possible for the sidewall insulator 7 to improve an environmental tolerance of the pixel section 100.

Further, in the solid-state imaging device 1, the protective film 9 covering the transparent electrode 6 and the wiring line 63 is formed in the effective pixel region 101 and the peripheral region 102, as illustrated in FIG. 1. This makes it possible to improve the environmental tolerance in the pixel section 100 in the effective pixel region 101 and the coupling section 8 in the peripheral region 102.

Additionally, in the peripheral region 102, the light-blocking film 10 that blocks light is formed on the protective film 9 on a side opposite to the wiring line 63. This makes it possible to block incidence of light in the peripheral region 102.

### <2. Second Embodiment>

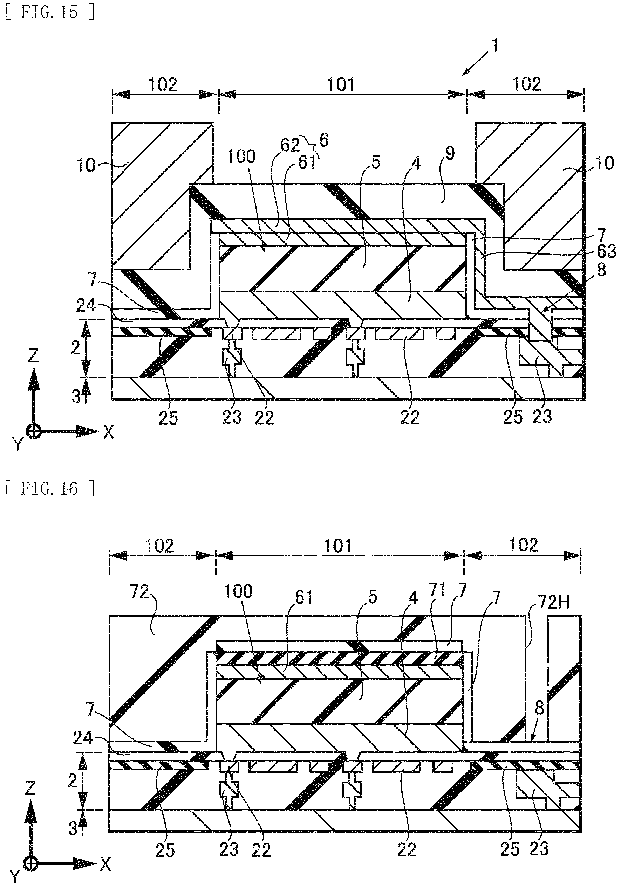

Description is given of the solid-state imaging device 1 according to a second embodiment of the present disclosure with reference to FIGs. 15 to 24. It is to be noted that, in the second embodiment and embodiments described hereinafter, the same components or substantially the same components as those of the solid-state imaging device 1 according to the first embodiment are denoted by the same reference numerals, and redundant descriptions thereof are omitted.

### [Configuration of Solid-State Imaging Device 1]

FIG. 15 illustrates an example of a longitudinal cross-sectional configuration of the solid-state imaging device 1. As illustrated in FIG. 15, in the solid-state imaging device 1 according to the second embodiment, the sidewall insulator 7 formed on the side surface of the pixel section 100 is also formed between the insulator 2 and the protective film 9 in the peripheral region 102. The sidewall insulator 7 formed on the side surface of the pixel section 100 and the peripheral region 102 is formed by the same insulating material and is formed in the same insulating layer. That is, the sidewall insulator 7 formed on the side surface of the pixel section 100 extends to the peripheral region 102.

Components other than the above-described components are the same or substantially the same as the components of the solid-state imaging device 1 according to the foregoing first embodiment.

### [Manufacturing Method of Solid-State Imaging Device 1]

Next, description is given of the manufacturing method of the solid-state imaging device 1 with reference to FIGs. 16 to 24 while referring to FIG. 15.

The sidewall insulator 7 is formed in the same manner as the process illustrated in FIG. 4 of the manufacturing method of the solid-state imaging device 1 according to the first embodiment (hereinafter, simply referred to as a "first manufacturing method"). The sidewall insulator 7 is formed on the entire surface including the top of the mask 71 in the effective pixel region 101 and the top of the insulator 2 in the peripheral region 102.

In the same manner as the process illustrated in FIG. 6 of the first manufacturing method, the mask 72 is formed on the entire surfaces of the effective pixel region 101 and the peripheral region 102, as illustrated in FIG. 16. The mask 72 is formed on the sidewall insulator 7 in each of the effective pixel region 101 and the peripheral region 102. In a location where the coupling section 8 (see FIG. 15) is formed in the peripheral region 102, the opening 72H is formed in the mask 72.

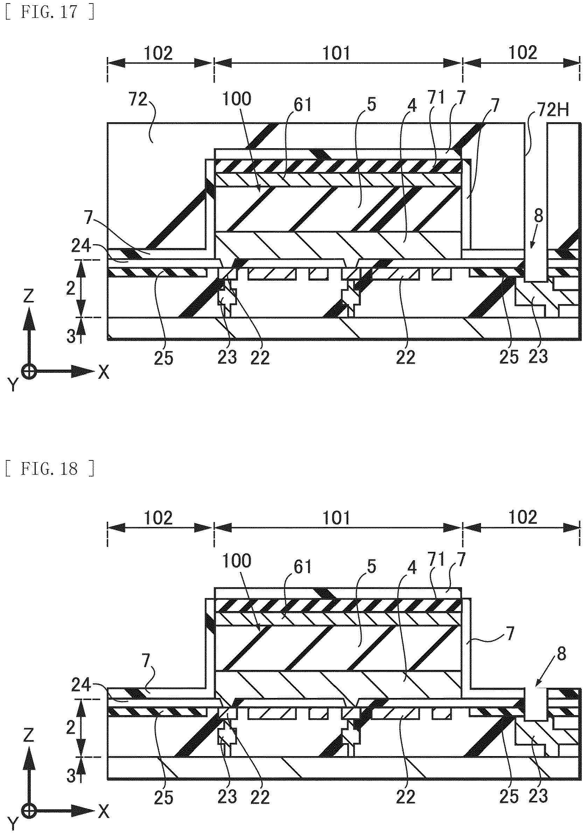

In the same manner as the process illustrated in FIG. 7 of the first manufacturing method, the sidewall insulator 7 and the insulator 2 exposed from the opening 72H of the mask 72 are removed to allow the surface of the wiring line 23 inside the insulator 2 to be exposed, as illustrated in FIG. 17. To remove the sidewall insulator 7 and the insulator 2, for example, the RIE method is used.

Thereafter, the mask 72 is removed in the same manner as the process illustrated in FIG. 8 of the first manufacturing method, as illustrated in FIG. 18.

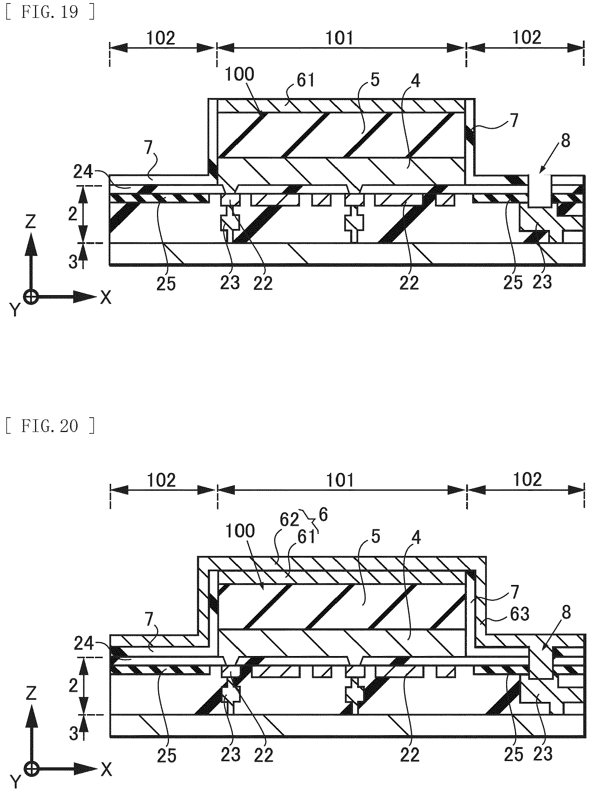

As illustrated in FIG. 19, in the effective pixel region 101, the mask 71 is selectively removed using a lift-off (Lift-off) method. Along with the removal of the mask 71, the sidewall insulator 7 on the mask 71 is removed in the effective pixel region 101.

In the same manner as the process illustrated in FIG. 10 of the first manufacturing method, the second transparent electrode 62 is formed on the entire surface including the top of the first transparent electrode 61 in the effective pixel region 101, the top of the insulator 2 in the peripheral region 102, and the top of the sidewall insulator 7 in the peripheral region 102, as illustrated in FIG. 20. In the effective pixel region 101, the second transparent electrode 62 is stacked on the first transparent electrode 61, thus allowing for formation of the transparent electrode 6 including the first transparent electrode 61 and the second transparent electrode 62.

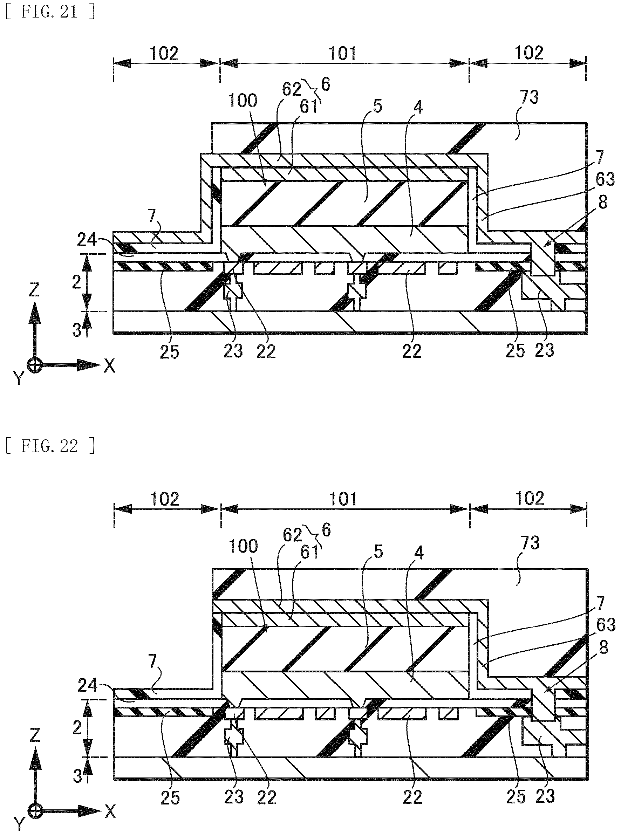

In the same manner as the process illustrated in FIG. 11 of the first manufacturing method, the mask 73 is formed that covers the top of the transparent electrode 6 in the effective pixel region 101 and a location from the top of the transparent electrode 6 to the top of the coupling section 8 (see FIG. 15), as illustrated in FIG. 21. Except a region where the wiring line 63 and the coupling section 8 are formed in the peripheral region 102, a surface of the second transparent electrode 62 is exposed from the mask 73.

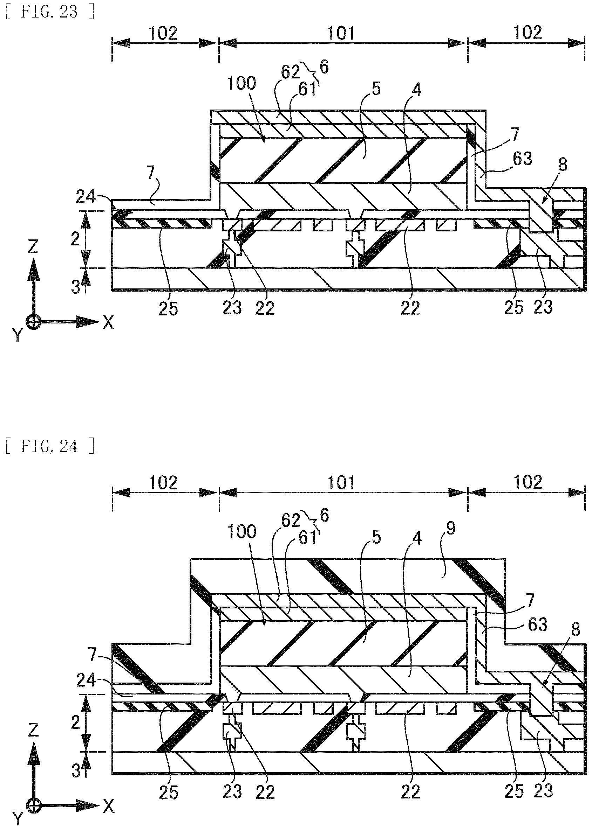

In the same manner as the process illustrated in FIG. 12 of the first manufacturing method, the extra second transparent electrode 62 in the peripheral region 102 is removed using the mask 73, as illustrated in FIG. 22. Subsequently, the mask 73 is removed as illustrated in FIG. 23.

This allows for formation of the wiring line 63 that is formed integrally with the second transparent electrode 62 of the transparent electrode 6, that is formed by the same transparent electrode material as that of the second transparent electrode 62, and that includes the same electrically-conductive layer as that of the second transparent electrode 62. The wiring line 63 is coupled to the wiring line 23 at the coupling section 8. In addition, in the pixel section 100, the wiring line 63 is electrically separated from the side surface of the transparent semiconductor 4, the side surface of the organic photoelectric conversion film 5, and the side surface of the first transparent electrode 61 of the transparent electrode 6, with the sidewall insulator 7 interposed therebetween.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102, as illustrated in FIG. 24. Subsequently, the light-blocking film 10 is formed on the protective film 9 in the peripheral region 102, as illustrated in FIG. 15 mentioned above.

When the series of manufacturing process ends, the solid-state imaging device 1 according to the second embodiment is completed.

### [Workings and Effects]

In the solid-state imaging device 1 according to the second embodiment, it is possible to achieve the same workings and effects or substantially the same workings and effects as the workings and effects achieved by the solid-state imaging device 1 according to the foregoing first embodiment.

In addition, the solid-state imaging device 1 includes the sidewall insulator 7 on the side surface of the organic photoelectric conversion film 5 and the side surface of the transparent semiconductor 4, as illustrated in FIG. 15. The wiring line 63 extends from the transparent electrode 6 to the coupling section 8 along the side surface of the organic photoelectric conversion film 5 and the side surface of the transparent semiconductor 4, with the sidewall insulator 7 interposed therebetween.

Here, the sidewall insulator 7 extends between the insulator 2 and the protective film 9 in the peripheral region 102. That is, the sidewall insulator 7 formed on the side surface of the organic photoelectric conversion film 5 and the side surface of the transparent semiconductor 4 is utilized in the peripheral region 102; the sidewall insulator 7 is able to increase an effective thickness of the insulator 2 or the protective film 9. This makes it possible to further improve the environmental tolerance in the peripheral region 102.

### <3.Third Embodiment>

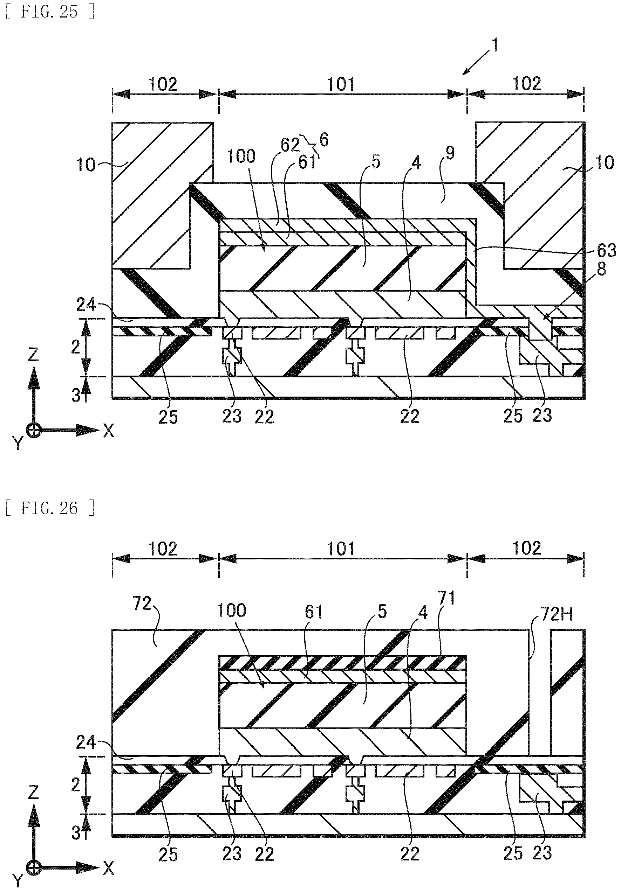

Description is given of the solid-state imaging device 1 according to a third embodiment of the present disclosure with reference to FIGs. 25 to 34.

### [Configuration of Solid-State Imaging Device 1]

FIG. 25 illustrates an example of a longitudinal cross-sectional configuration of the solid-state imaging device 1. As illustrated in FIG. 25, in the solid-state imaging device 1 according to the third embodiment, the sidewall insulator 7 is not formed, that is formed on the side surface of the pixel section 100 in the solid-state imaging device 1 according to the first embodiment or the second embodiment (see FIGs. 1 and 15). It is to be noted that, although the sidewall insulator 7 is not actively formed, an unillustrated natural oxide film is effectively formed on the side surface of the pixel section 100, at least on the side surface of the transparent semiconductor 4. That is, the wiring line 63 and the transparent semiconductor 4 are electrically separated from each other by the natural oxide film.

Components other than the above-described components are the same or substantially the same as the components of the solid-state imaging device 1 according to the foregoing first embodiment or second embodiment.

### [Manufacturing Method of Solid-State Imaging Device 1]

Next, description is given of the manufacturing method of the solid-state imaging device 1 with reference to FIGs. 26 to 34 while referring to FIG. 25.

First, in the same manner as the process illustrated in FIG. 3 of the first manufacturing method, in the effective pixel region 101, the transparent semiconductor 4, the organic photoelectric conversion film 5, the first transparent electrode 61 of the transparent electrode 6, and the mask 71 are each sequentially formed on the insulator 2. The first transparent electrode 61, the organic photoelectric conversion film 5, and the transparent semiconductor 4 are each patterned using the mask 71 of the uppermost layer.

Here, the process of forming the sidewall insulator 7 illustrated in FIGs. 4 and 5 of the first manufacturing method is omitted. Then, in the same manner as the process illustrated in FIG. 6 of the first manufacturing method, the mask 72 is formed on the entire surfaces of the effective pixel region 101 and the peripheral region 102, as illustrated in FIG. 26. The mask 72 is formed on the mask 71 in the effective pixel region 101, and is formed on the insulator 2 in the peripheral region 102. In a location where the coupling section 8 (see FIG. 25) is formed in the peripheral region 102, the opening 72H is formed in the mask 72.

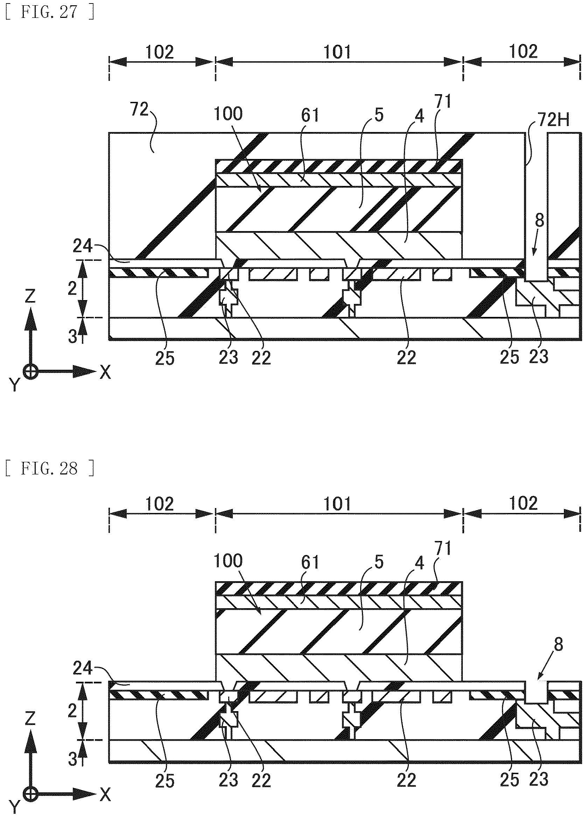

In the same manner as the process illustrated in FIG. 7 of the first manufacturing method, the insulator 2 exposed from the opening 72H of the mask 72 is removed to allow the surface of the wiring line 23 inside the insulator 2 to be exposed, as illustrated in FIG. 27. This allows the coupling section 8 to be substantially formed.

Thereafter, the mask 72 is removed as illustrated in FIG. 28.

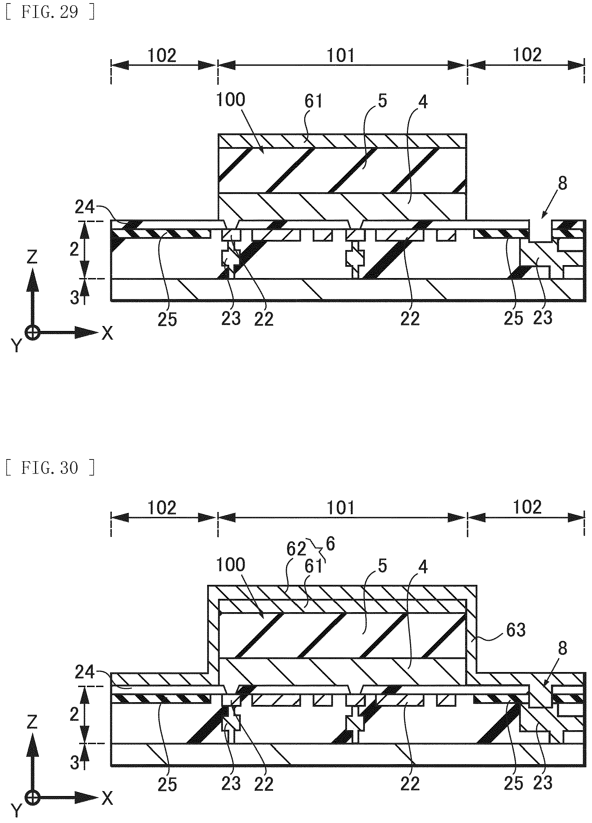

In the same manner as the process illustrated in FIG. 9 of the first manufacturing method, in the effective pixel region 101, the mask 71 on the first transparent electrode 61 is removed, as illustrated in FIG. 29. When the mask 71 is removed, the surface of the first transparent electrode 61 is exposed.

In the same manner as the process illustrated in FIG. 10 of the first manufacturing method, the second transparent electrode 62 is formed on the entire surface including the top of the first transparent electrode 61 in the effective pixel region 101 and the top of the insulator 2 in the peripheral region 102, as illustrated in FIG. 30. In the effective pixel region 101, the second transparent electrode 62 is stacked on the first transparent electrode 61, thus allowing for formation of the transparent electrode 6 including the first transparent electrode 61 and the second transparent electrode 62.

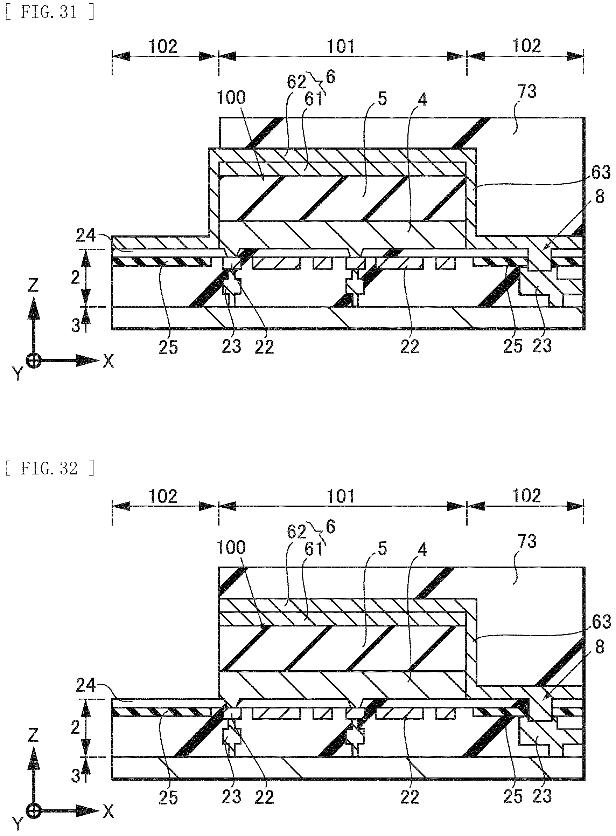

In the same manner as the process illustrated in FIG. 11 of the first manufacturing method, the mask 73 is formed that covers the top of the transparent electrode 6 in the effective pixel region 101 and a location from the top of the transparent electrode 6 to the top of the coupling section 8 (see FIG. 25), as illustrated in FIG. 31.

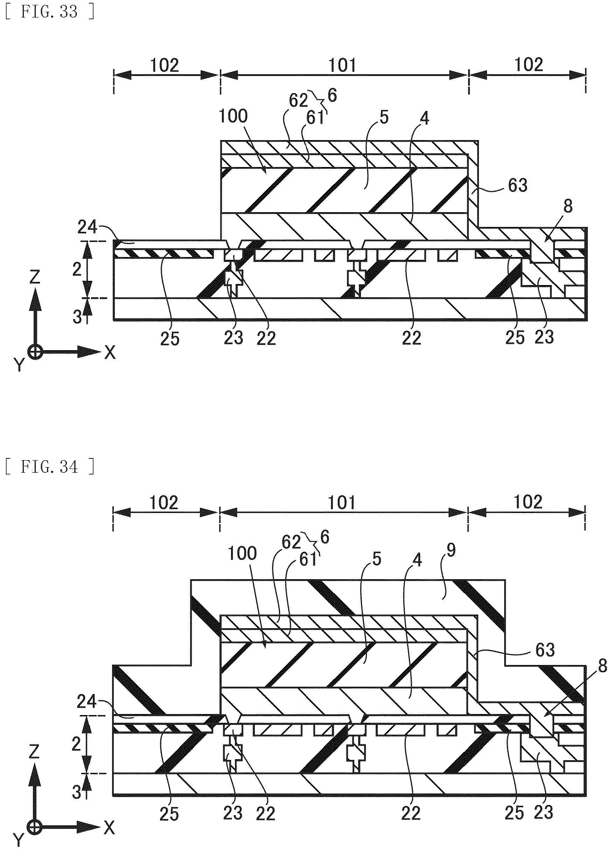

In the same manner as the process illustrated in FIG. 12 of the first manufacturing method, the extra second transparent electrode 62 in the peripheral region 102 is removed using the mask 73, as illustrated in FIG. 32. Subsequently, the mask 73 is removed as illustrated in FIG. 33.

This allows for formation of the wiring line 63 that is formed integrally with the second transparent electrode 62 of the transparent electrode 6, that is formed by the same transparent electrode material as that of the second transparent electrode 62, and that includes the same electrically-conductive layer as that of the second transparent electrode 62. The wiring line 63 is coupled to the wiring line 23 at the coupling section 8. In addition, the wiring line 63 is electrically separated from the side surface of the transparent semiconductor 4, in particular, of the pixel section 100, with an unillustrated natural oxide film interposed therebetween.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102, as illustrated in FIG. 34. Subsequently, the light-blocking film 10 is formed on the protective film 9 in the peripheral region 102, as illustrated in FIG. 25 mentioned above.

When the series of manufacturing process ends, the solid-state imaging device 1 according to the third embodiment is completed.

### [Workings and Effects]

In the solid-state imaging device 1 according to the third embodiment, it is possible to achieve the same workings and effects or substantially the same workings and effects as the workings and effects achieved by the solid-state imaging device 1 according to the foregoing first embodiment.

In addition, in the solid-state imaging device 1, the sidewall insulator 7 is not actively formed on the side surface of the pixel section 100, as illustrated in FIG. 25. This makes it possible to omit the component corresponding to the sidewall insulator 7 and thus to further simplify the wiring structure.

Additionally, it is possible to omit a process corresponding to the process of forming the sidewall insulator 7 and thus to reduce the number of manufacturing processes of the solid-state imaging device 1. As a result, it is possible to improve a yield of the manufacturing of the solid-state imaging device 1.

### <4. Fourth Embodiment>

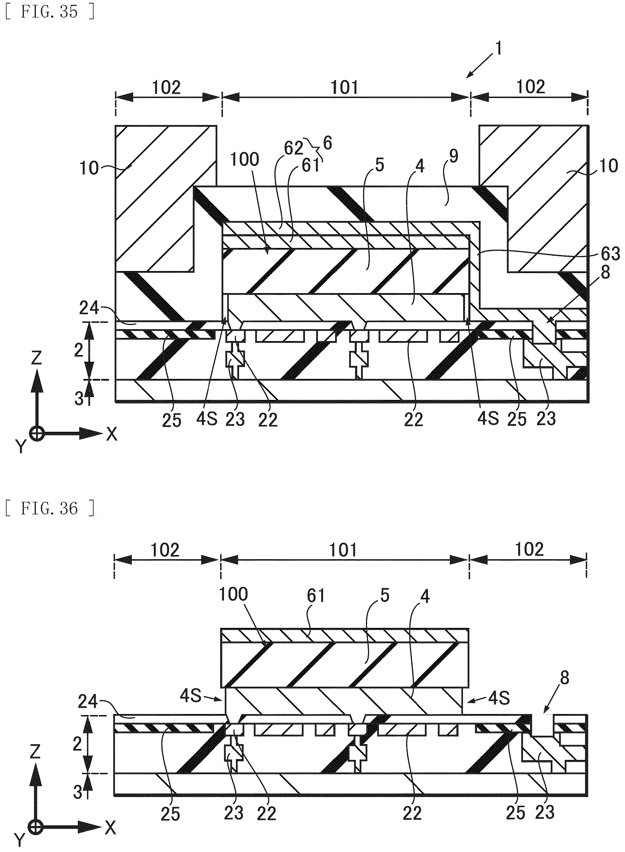

Description is given of the solid-state imaging device 1 according to a fourth embodiment of the present disclosure with reference to FIGs. 35 to 41.

### [Configuration of Solid-State Imaging Device 1]

FIG. 35 illustrates an example of a longitudinal cross-sectional configuration of the solid-state imaging device 1. As illustrated in FIG. 35, in the solid-state imaging device 1 according to the fourth embodiment, the sidewall insulator 7 is not formed in the same manner as the solid-state imaging device 1 according to the third embodiment (see FIG. 25). Further, in the solid-state imaging device 1, a cavity 4S is formed between the side surface of the transparent semiconductor 4 of the pixel section 100 and the wiring line 63.

The side surface of the transparent semiconductor 4 is formed inside the side surface of the organic photoelectric conversion film 5 in the effective pixel region 101, thereby forming the cavity 4S between the side surface of the transparent semiconductor 4 and the wiring line 63. The inside of the cavity 4S is filled with a gas such as air. The transparent semiconductor 4 and the wiring line 63 are electrically separated from each other by a gas.

Components other than the above-described components are the same or substantially the same as the components of the solid-state imaging device 1 according to the foregoing third embodiment.

### [Manufacturing Method of Solid-State Imaging Device 1]

Next, description is given of the manufacturing method of the solid-state imaging device 1 with reference to FIGs. 36 to 41 while referring to FIG. 35.

In the same manner as the process illustrated in FIG. 29 of the manufacturing method of the solid-state imaging device 1 according to the third embodiment (hereinafter, simply referred to as a "third manufacturing method"), the mask 71 on the first transparent electrode 61 is removed in the effective pixel region 101. When the mask 71 is removed, the surface of the first transparent electrode 61 is exposed.

As illustrated in FIG. 36, side etching is performed on the side surface of the transparent semiconductor 4 in the effective pixel region 101. As the side etching, for example, an isotropic etching method is used, in which etching selectivity of the transparent semiconductor 4 is large with respect to that of each of the organic photoelectric conversion film 5 and the insulator 2.

This causes the side surface of the transparent semiconductor 4 to be retracted to the inside of the effective pixel region 101, thus allowing for formation of the cavity 4S.

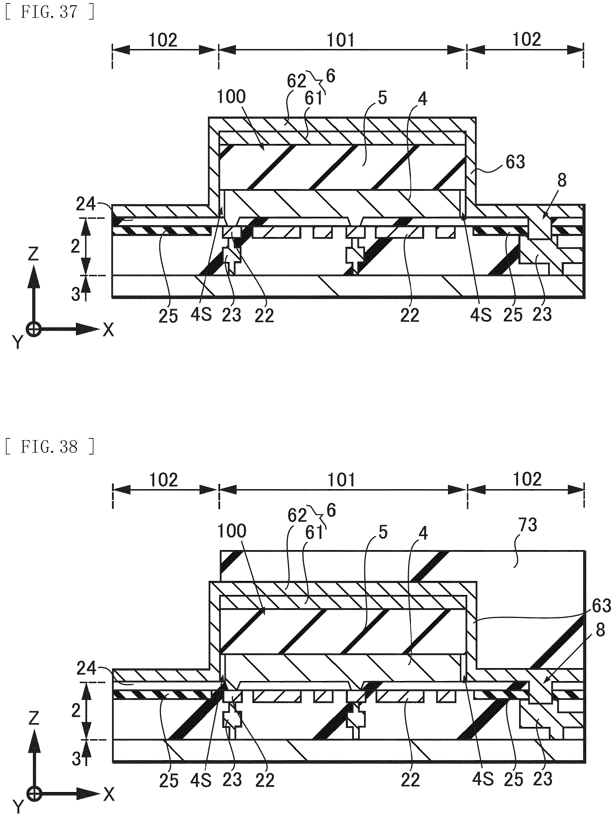

In the same manner as the process illustrated in FIG. 30 of the third manufacturing method, the second transparent electrode 62 is formed on the entire surface including the top of the first transparent electrode 61 in the effective pixel region 101 and the top of the insulator 2 in the peripheral region 102, as illustrated in FIG. 37. In the effective pixel region 101, the second transparent electrode 62 is stacked on the first transparent electrode 61, thus allowing for formation of the transparent electrode 6 including the first transparent electrode 61 and the second transparent electrode 62.

In the same manner as the process illustrated in FIG. 31 of the third manufacturing method, the mask 73 is formed that covers the top of the transparent electrode 6 in the effective pixel region 101 and a location from the top of the transparent electrode 6 to the top of the coupling section 8 (see FIG. 35), as illustrated in FIG. 38.

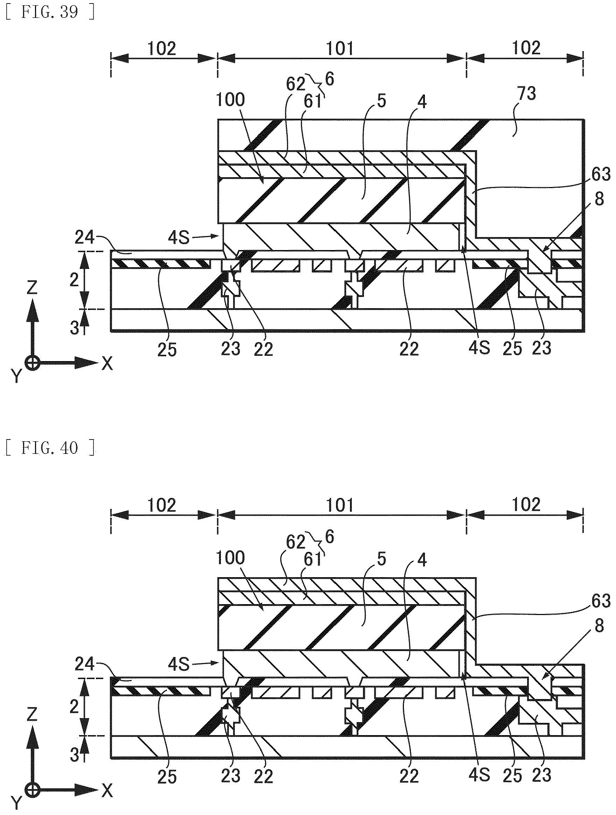

In the same manner as the process illustrated in FIG. 32 of the third manufacturing method, the extra second transparent electrode 62 in the peripheral region 102 is removed using the mask 73, as illustrated in FIG. 39. Subsequently, the mask 73 is removed as illustrated in FIG. 40.

This allows for formation of the wiring line 63 that is formed integrally with the second transparent electrode 62 of the transparent electrode 6, that is formed by the same transparent electrode material as that of the second transparent electrode 62, and that includes the same electrically-conductive layer as that of the second transparent electrode 62. The wiring line 63 is coupled to the wiring line 23 at the coupling section 8. In addition, the cavity 4S is formed on the side surface of the transparent semiconductor 4, in particular, of the pixel section 100, thus allowing the wiring line 63 to be electrically separated from the side surface of the transparent semiconductor 4, with the cavity 4S (a gas filled inside the cavity 4S) interposed therebetween.

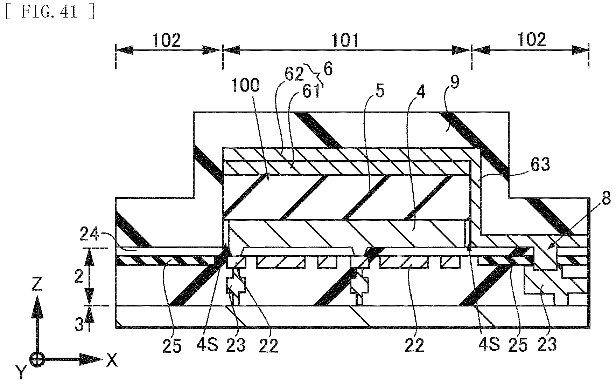

In the same manner as the process illustrated in FIG. 34 of the third manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102, as illustrated in FIG. 41. Subsequently, the light-blocking film 10 is formed on the protective film 9 in the peripheral region 102, as illustrated in FIG. 35 mentioned above.

When the series of manufacturing process ends, the solid-state imaging device 1 according to the fourth embodiment is completed.

### [Workings and Effects]

In the solid-state imaging device 1 according to the fourth embodiment, it is possible to achieve the same workings and effects or substantially the same workings and effects as the workings and effects achieved by the solid-state imaging device 1 according to the foregoing third embodiment.

In addition, the solid-state imaging device 1 is provided with the cavity 4S between the side surface of the transparent semiconductor 4 of the pixel section 100 and the wiring line 63, as illustrated in FIG. 35. The cavity 4S is formed by disposing the side surface of the transparent semiconductor 4 inside the side surface of the organic photoelectric conversion film 5 in the effective pixel region 101. That is, the cavity 4S is formed by side etching.

Therefore, the wiring line 63 is electrically separated surely by the cavity 4S (or a gas filled in the cavity 4S) from the pixel section 100, specifically from the transparent semiconductor 4.

### <5. Fifth Embodiment>

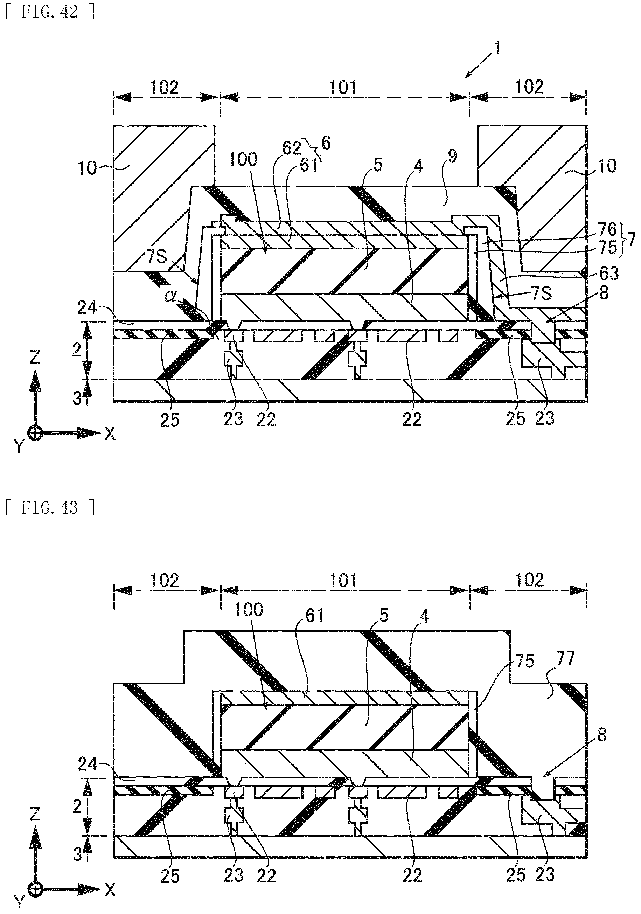

Description is given of the solid-state imaging device 1 according to a fifth embodiment of the present disclosure with reference to FIGs. 42 to 47. As for the solid-state imaging device 1 according to any of the fifth to ninth embodiments, description is given of an example in which the structure of the sidewall insulator 7 is changed.

### [Configuration of Solid-State Imaging Device 1]

FIG. 42 illustrates an example of a longitudinal cross-sectional configuration of the solid-state imaging device 1. As illustrated in FIG. 42, the solid-state imaging device 1 according to the fifth embodiment includes the sidewall insulator 7, in the same manner as the solid-state imaging device 1 according to the first embodiment. The sidewall insulator 7 is formed on the side surface of the pixel section 100, i.e., at least on the side surface of the organic photoelectric conversion film 5 and the side surface of the transparent semiconductor 4. In the fifth embodiment, the sidewall insulator 7 includes a first sidewall insulator 75 and a second sidewall insulator 76 stacked on the first sidewall insulator 75. The first sidewall insulator 75 is a component that is the same or substantially the same as the sidewall insulator 7 of the solid-state imaging device 1 according to the first embodiment.

The second sidewall insulator 76 of the sidewall insulator 7 has an inclined wall surface 7S extending from the transparent electrode 6 toward the transparent semiconductor 4 and from the effective pixel region 101 to the peripheral region 102 on the side surface of the pixel section 100. The inclined wall surface 7S is formed; therefore, as for the thickness from the side surface of the organic photoelectric conversion film 5, the sidewall insulator 7 formed on the side surface of the organic photoelectric conversion film 5 is formed to be thicker than the sidewall insulator 7, formed on the side surface of the transparent electrode 6, in the thickness from the side surface of the transparent electrode 6. Likewise, as for the thickness from the side surface of the transparent semiconductor 4, the sidewall insulator 7 formed on the side surface of the transparent semiconductor 4 is formed to be thicker than the sidewall insulator 7, formed on the side surface of the organic photoelectric conversion film 5, in the thickness from the side surface of the organic photoelectric conversion film 5. The inclined wall surface 7S, in this example, is formed to be planar.

In addition, an inclination angle α, on a side of the effective pixel region 101, formed between the inclined wall surface 7S and a surface of the insulator 2 is set to, for example, 20 degrees or more and less than 90 degrees. Preferably, the inclination angle α is set to be 20 degrees or more and less than 60 degrees.

Setting the lower limit of the inclination angle α makes it possible to reduce an occupied area of the sidewall insulator 7 in the peripheral region 102. In addition, setting the upper limit of the inclination angle α makes it possible to improve a step coverage of the wiring line 63 formed along the inclined wall surface 7S of the sidewall insulator 7 from the transparent electrode 6.

Components other than the above-described components are the same or substantially the same as the components of the solid-state imaging device 1 according to the foregoing first embodiment.

### [Manufacturing Method of Solid-State Imaging Device 1]

Next, description is given of the manufacturing method of the solid-state imaging device 1 with reference to FIGs. 43 to 47 while referring to FIG. 42.

First, in the same manner as the process of forming the sidewall insulator 7 illustrated in FIG. 5 of the first manufacturing method, the first sidewall insulator 75 is formed on the side surface of the pixel section 100 (see FIGs. 5 and 43). In the same manner as the sidewall insulator 7 illustrated in FIG. 5, the first sidewall insulator 75, in this example, is formed by AlO, for example. The ALD method is used to form the first sidewall insulator 75.

In the same manner as the process illustrated in FIGs. 6 to 8 of the first manufacturing method, the insulator 2 is removed in the peripheral region 102 to allow the surface of the wiring line 23 inside the insulator 2 to be exposed.

Subsequently, in the same manner as the process illustrated in FIG. 9 of the first manufacturing method, the mask 71 on the first transparent electrode 61 is removed in the effective pixel region 101. When the mask 71 is removed, the surface of the first transparent electrode 61 is exposed.

As illustrated in FIG. 43, an insulating film 77 is formed on the entire surface including the top of the first transparent electrode 61 in the effective pixel region 101 and the top of the insulator 2 in the peripheral region 102. The insulating film 77 forms the second sidewall insulator 76 of the sidewall insulator 7, and thus is formed by, for example, AlO having an insulation property and an environmental tolerance. The insulating film 77 is formed by, for example, a sputtering method or the ALD method. The insulating film 77 is formed to have a thickness that allows the pixel section 100 to be completely embedded therein, e.g., a thickness of 1 nm or more and 100 µm or less.

The pixel section 100 protrudes in the arrow-Z direction from the insulator 2, thus generating undulation on a surface of the insulating film 77. That is, the surface of the insulating film 77 is high in the effective pixel region 101, and is lower in the peripheral region 102 than in the effective pixel region 101.

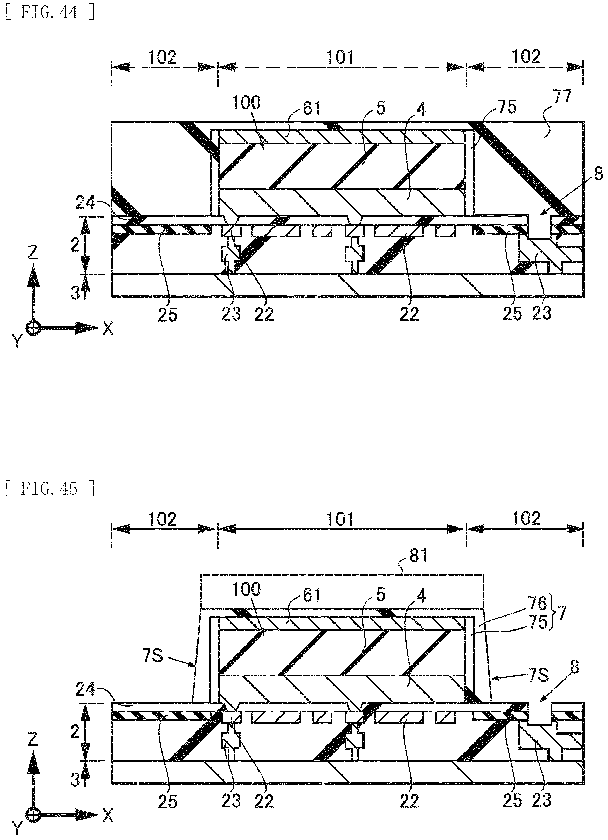

As illustrated in FIG. 44, the surface of the insulating film 77 is planarized. A chemical mechanical polishing (CMP: Chemical Mechanical Polishing) method or an etch-back method is used for the planarization.

Next, a mask 81 is formed on the insulating film 77 in the effective pixel region 101. The mask 81 is indicated using a broken line in FIG. 45. As the mask 81, for example, a photoresist is used.

As illustrated in FIG. 45, the insulating film 77 in the peripheral region 102 is removed using the mask 81. For example, a dry etching method is used to remove the insulating film 77. Here, the etching condition is appropriately adjusted, and the second sidewall insulator 76 having the inclined wall surface 7S is formed on the side surface of the pixel section 100 from the insulating film 77.

Thus, the sidewall insulator 7 is completed by the first sidewall insulator 75 formed in advance on the side surface of the pixel section 100 and the second sidewall insulator 76 newly formed on the first sidewall insulator 75.

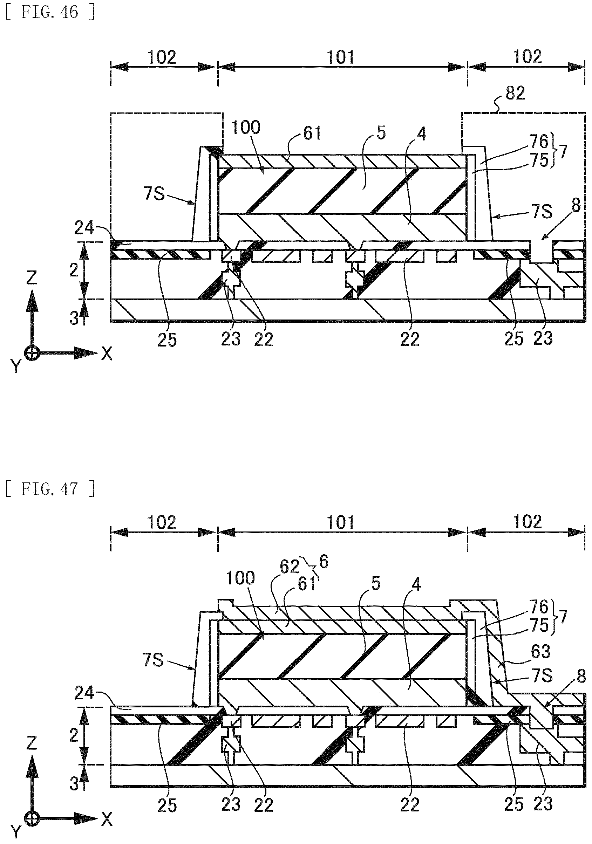

Subsequently, a mask 82 is formed that covers the top of the insulator 2 and the top of the sidewall insulator 7 in the peripheral region 102. The mask 82 is indicated using a broken line in FIG. 46. As the mask 82, for example, a photoresist is used in the same manner as the mask 81.

As illustrated in FIG. 46, the insulating film 77 remaining on the first transparent electrode 61 is removed in the effective pixel region 101 using the mask 82. For example, the dry etching method is used to remove the insulating film 77. The removal of the insulating film 77 allows the surface of the first transparent electrode 61 to be exposed. The mask 82 is then removed.

It is to be noted that, in the removal of the insulating film 77 remaining in the effective pixel region 101, the coupling section 8 in the peripheral region 102 is covered with the mask 82. Therefore, the surface of the wiring line 23 to be exposed in the coupling section 8 is prevented from being damaged by etching.

In the same manner as the process illustrated in FIGs. 10 to 13 of the first manufacturing method, the second transparent electrode 62 is formed on the first transparent electrode 61 in the effective pixel region 101, as illustrated in FIG. 47. When the second transparent electrode 62 is formed, the transparent electrode 6 is completed by the first transparent electrode 61 and the second transparent electrode 62 formed on the first transparent electrode 61.

Further, when the second transparent electrode 62 is formed, the wiring line 63 is formed, in the same process, extending from the second transparent electrode 62 to the coupling section 8 along the inclined wall surface 7S of the sidewall insulator 7.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102 (see FIG. 42). Subsequently, the light-blocking film 10 is formed on the protective film 9 in the peripheral region 102, as illustrated in FIG. 42 mentioned above.

When the series of manufacturing process ends, the solid-state imaging device 1 according to the fifth embodiment is completed.

### [Workings and Effects]

In the solid-state imaging device 1 according to the fifth embodiment, it is possible to achieve the same workings and effects or substantially the same workings and effects as the workings and effects achieved by the solid-state imaging device 1 according to the foregoing first embodiment.

In addition, in the solid-state imaging device 1, the sidewall insulator 7 is provided with the inclined wall surface 7S extending from the transparent electrode 6 toward the transparent semiconductor 4 and from the effective pixel region 101 to the peripheral region, as illustrated in FIG. 42.

It is therefore possible to improve a step coverage (adherence) of the wiring line 63 extending from the transparent electrode 6 of the pixel section 100 to the coupling section 8 along the sidewall insulator 7. That is, it is possible to effectively suppress or prevent a reduction in the cross-sectional area of the wiring line 63 and thus to reduce the resistance value. Additionally, it is possible to effectively prevent disconnection of the wiring line 63.

In addition, the sidewall insulator 7 is provided with the inclined wall surface 7S; therefore, as for the thickness from the side surface of the organic photoelectric conversion film 5, the sidewall insulator 7 formed on the side surface of the organic photoelectric conversion film 5 is formed to be thicker than the sidewall insulator 7, formed on the side surface of the transparent electrode 6, in the thickness from the side surface of the transparent electrode 6. It is therefore possible to improve the environmental tolerance in the side surface of the organic photoelectric conversion film 5. This effect is also achieved in the same manner in the side surface of the transparent semiconductor 4.

Further, the inclination angle α, on the side of the effective pixel region 101, formed between the inclined wall surface 7S of the sidewall insulator 7 and the surface of the insulator 2 is set to 20 degrees or more and less than 90 degrees in the solid-state imaging device 1, as illustrated in FIG. 42. When the inclination angle α is equal to or more than the lower limit value described above, it is possible to sufficiently improve the step coverage of the wiring line 63. It is possible, of course, to sufficiently improve the environmental tolerance of the pixel section 100.

### <6. Sixth Embodiment>

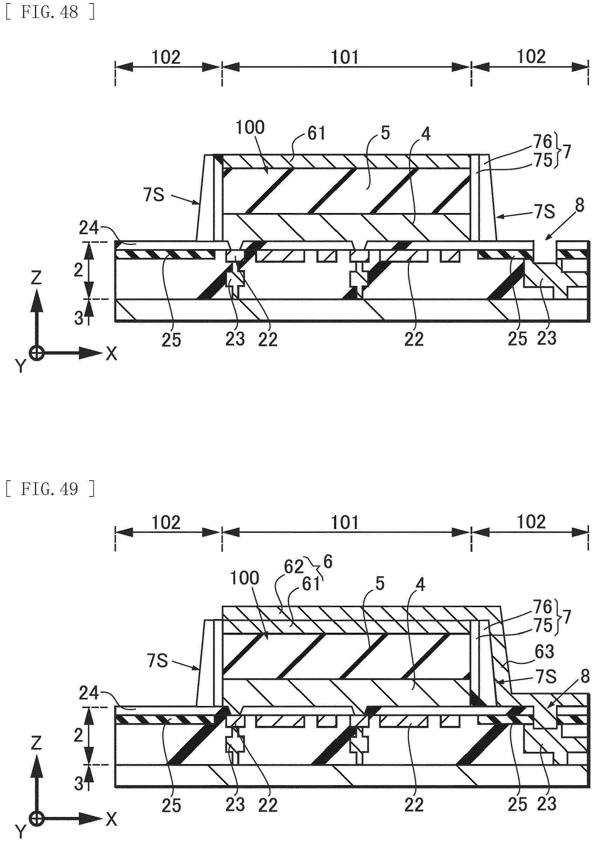

Description is given of the solid-state imaging device 1 according to a sixth embodiment of the present disclosure with reference to FIGs. 48 and 49. The sixth embodiment describes a modification example of the manufacturing method of the solid-state imaging device 1 according to the fifth embodiment.

### [Manufacturing Method of Solid-State Imaging Device 1]

First, the insulating film 77 is formed in the same manner as the process illustrated in FIG. 43 of the manufacturing method of the solid-state imaging device 1 according to the fifth embodiment (hereinafter, simply referred to as a "fifth manufacturing method"). The insulating film 77 is formed on the entire surface including the top of the first transparent electrode 61 in the effective pixel region 101 and the top of the insulator 2 in the peripheral region 102. As a matter of course, the insulating film 77 is also formed on the first sidewall insulator 75 on the side surface of the pixel section 100.

As illustrated in FIG. 48, the insulating film 77 formed on the first transparent electrode 61 in the effective pixel region 101 and on the insulator 2 in the peripheral region 102 is removed. The removal of the insulating film 77 allows the surface of the first transparent electrode 61 to be exposed in the effective pixel region 101.

At this time, due to a step difference shape of the pixel section 100, the insulating film 77 formed on the insulator 2 in the peripheral region 102 is formed to be thick, as for the thickness, at a location of the side surface of the pixel section 100, and thus a portion of the insulating film 77 remains. The portion of the insulating film 77 is formed as the second sidewall insulator 76. The inclined wall surface 7S is formed on the second sidewall insulator 76. When the second sidewall insulator 76 is formed, the sidewall insulator 7 including the first sidewall insulator 75 and the second sidewall insulator 76 is completed.

In the same manner as the process illustrated in FIG. 47 of the fifth manufacturing method, the second transparent electrode 62 is formed on the first transparent electrode 61 in the effective pixel region 101, as illustrated in FIG. 49. When the second transparent electrode 62 is formed, the transparent electrode 6 is completed by the first transparent electrode 61 and the second transparent electrode 62 formed on the first transparent electrode 61.

Further, when the second transparent electrode 62 is formed, the wiring line 63 is formed, in the same process, extending from the second transparent electrode 62 to the coupling section 8 along the inclined wall surface 7S of the sidewall insulator 7.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102 (see FIG. 42). Subsequently, the light-blocking film 10 is formed on the protective film 9 in the peripheral region 102, as illustrated in FIG. 42 mentioned above.

When the series of manufacturing process ends, the solid-state imaging device 1 according to the sixth embodiment is completed.

### [Workings and Effects]

In the solid-state imaging device 1 according to the sixth embodiment, it is possible to achieve the same workings and effects or substantially the same workings and effects as the workings and effects achieved by the solid-state imaging device 1 according to the foregoing fifth embodiment.

In addition, in the manufacturing method of the solid-state imaging device 1, after the insulating film 77 illustrated in FIG. 43 of the fifth manufacturing method is formed, the insulating film 77 in the effective pixel region 101 and the peripheral region 102 is removed, and the surface of the first transparent electrode 61 is exposed, with the sidewall insulator 7 being formed, as illustrated in FIG. 48. That is, the process of planarizing the insulating film 77 illustrated in FIG. 44, the process of forming the mask 81 and the second sidewall insulator 76 illustrated in FIG. 45, and the process of removing the mask 82 and the remaining insulating film 77 illustrated in FIG. 46 in the fifth manufacturing method constitute one process.

It is therefore possible, in the manufacturing method of the solid-state imaging device 1, to significantly reduce the number of manufacturing processes. Additionally, the reduction in the number of manufacturing processes makes it possible to improve a yield of the manufacturing of the solid-state imaging device 1.

### <7. Seventh Embodiment>

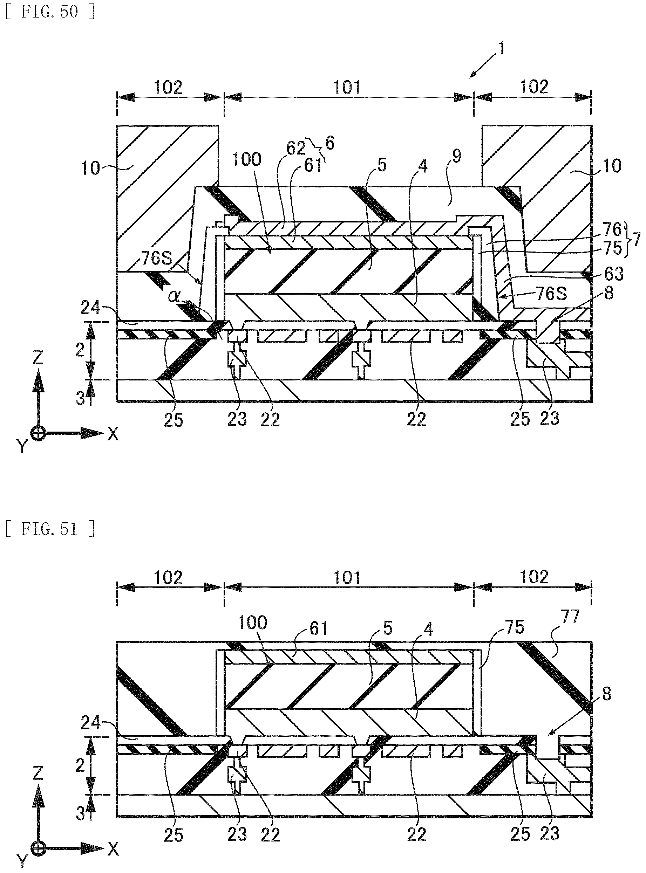

Description is given of the solid-state imaging device 1 according to the seventh embodiment of the present disclosure with reference to FIGs. 50 to 54.

### [Configuration of Solid-State Imaging Device 1]

FIG. 50 illustrates an example of a longitudinal cross-sectional configuration of the solid-state imaging device 1. As illustrated in FIG. 50, the solid-state imaging device 1 according to the seventh embodiment includes the transparent electrode 6, in the same manner as the solid-state imaging device 1 according to the fifth embodiment or the sixth embodiment. In the solid-state imaging device 1 according to any of the first to sixth embodiments, the transparent electrode 6 includes the first transparent electrode 61 and the second transparent electrode 62 formed on the first transparent electrode 61 and formed by the same transparent electrode material as that of the first transparent electrode 61. In contrast, in the solid-state imaging device 1 according to the seventh embodiment, the transparent electrode 6 includes the first transparent electrode 61 and the second transparent electrode 62 formed by a transparent electrode material different from that of the first transparent electrode 61.

Here, the first transparent electrode 61 is formed by IZO, for example. The second transparent electrode 62 is formed by ITO, for example. A resistance value of ITO is smaller than a resistance value of IZO. That is, the transparent electrode 6 is formed by stacking the first transparent electrode 61 and the second transparent electrode 62 that have resistance values different from each other.

In addition, the wiring line 63 that couples the transparent electrode 6 and the coupling section 8 to each other is formed by the same transparent electrode material and formed in the same electrically-conductive layer as those of the second transparent electrode 62. That is, the wiring line 63, in this example, is formed by ITO, for example.

Components other than the above-described components are the same or substantially the same as the components of the solid-state imaging device 1 according to the foregoing fifth embodiment or sixth embodiment.

### [Manufacturing Method of Solid-State Imaging Device 1]

Next, description is given of the manufacturing method of the solid-state imaging device 1 with reference to FIGs. 51 to 54 while referring to FIG. 50.

First, in the same manner as the process illustrated in FIG. 43 of the fifth manufacturing method, the insulating film 77 is formed on the entire surface including the top of the first transparent electrode 61 in the effective pixel region 101 and the top of the insulator 2 in the peripheral region 102.

Subsequently, in the same manner as the process illustrated in FIG. 44 of the fifth manufacturing method, the surface of the insulating film 77 is planarized as illustrated in FIG. 51. The CMP method or the etch-back method is used for the planarization.

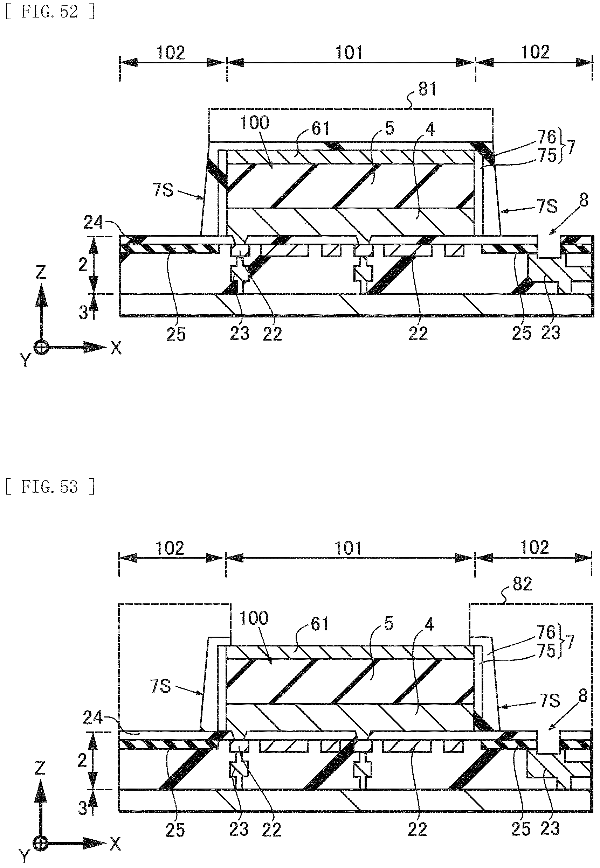

In the same manner as the process illustrated in FIG. 45 of the fifth manufacturing method, the mask 81 is formed on the insulating film 77 in the effective pixel region 101, and the insulating film 77 in the peripheral region 102 is removed using the mask 81, as illustrated in FIG. 52. This allows for formation of the second sidewall insulator 76 having the inclined wall surface 7S on the side surface of the pixel section 100 from the insulating film 77. When the second sidewall insulator 76 is formed, the sidewall insulator 7 is completed by the first sidewall insulator 75 formed in advance on the side surface of the pixel section 100 and the second sidewall insulator 76 newly formed on the first sidewall insulator 75.

In the same manner as the process illustrated in FIG. 46 of the fifth manufacturing method, the mask 82 is formed that covers the top of the insulator 2 and the top of the sidewall insulator 7 in the peripheral region 102, and the mask 82 is used to remove the insulating film 77 remaining on the first transparent electrode 61 in the effective pixel region 101, as illustrated in FIG. 53. The removal of the insulating film 77 allows the surface of the first transparent electrode 61 to be exposed. The mask 82 is then removed.

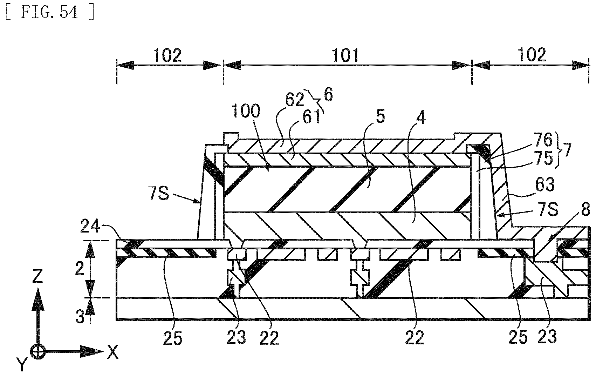

In the same manner as the process illustrated in FIG. 47 of the fifth manufacturing method, the second transparent electrode 62 is formed on the first transparent electrode 61 in the effective pixel region 101, as illustrated in FIG. 54. In this process, the second transparent electrode 62 is formed by a transparent electrode material different from that of the first transparent electrode 61. When the second transparent electrode 62 is formed, the transparent electrode 6 is completed by the first transparent electrode 61 and the second transparent electrode 62 formed on the first transparent electrode 61.

Further, when the second transparent electrode 62 is formed, the wiring line 63 is formed, in the same process, extending from the second transparent electrode 62 to the coupling section 8 along the inclined wall surface 7S of the sidewall insulator 7.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102 (see FIG. 50). Subsequently, the light-blocking film 10 is formed on the protective film 9 in the peripheral region 102, as illustrated in FIG. 50 mentioned above.

When the series of manufacturing process ends, the solid-state imaging device 1 according to the seventh embodiment is completed.

### [Workings and Effects]

In the solid-state imaging device 1 according to the seventh embodiment, it is possible to achieve the same workings and effects or substantially the same workings and effects as the workings and effects achieved by the solid-state imaging device 1 according to the foregoing fifth embodiment.

In addition, in the solid-state imaging device 1, the transparent electrode 6 is formed by a transparent electrode material to allow a resistance value of the second transparent electrode 62 to be smaller than a resistance value of the first transparent electrode 61, as illustrated in FIG. 50. It is therefore possible, in the effective pixel region 101, to reduce the resistance value of the transparent electrode 6 of the pixel section 100, thus making it possible to achieve uniform photoelectric conversion across the entire region of the pixel section 100.

Further, in the solid-state imaging device 1, the wiring line 63 is formed by the same transparent electrode material as that of the second transparent electrode 62, as illustrated in FIG. 50, thus making it possible to reduce the wiring resistance of the wiring line 63.

### <8. Eighth Embodiment>

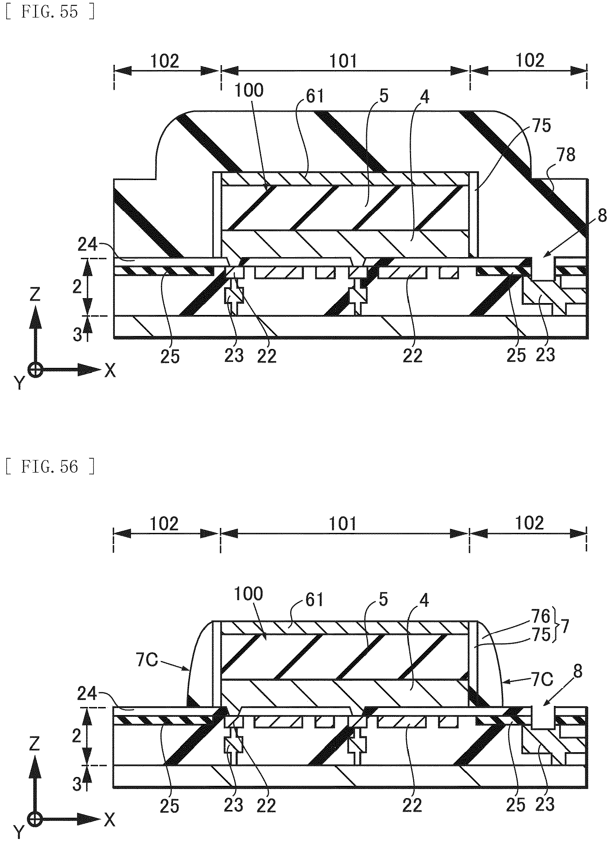

Description is given of the solid-state imaging device 1 according to an eighth embodiment of the present disclosure with reference to FIGs. 55 and 56. The eighth embodiment describes a modification example of the manufacturing method of the solid-state imaging device 1 according to the sixth embodiment.

### [Manufacturing Method of Solid-State Imaging Device 1]

First, an insulating film 78 is formed as illustrated in FIG. 55 in the same manner as the process illustrated in FIG. 43 of the manufacturing method of the solid-state imaging device 1 according to the sixth embodiment (hereinafter, simply referred to as a "sixth manufacturing method"). The insulating film 78 is formed on the entire surface including the top of the first transparent electrode 61 in the effective pixel region 101 and the top of the insulator 2 in the peripheral region 102. As a matter of course, the insulating film 78 is also formed on the first sidewall insulator 75 on the side surface of the pixel section 100.

Here, AlO is used as the insulating film 78, in the same manner as the insulating film 77 of the solid-state imaging device 1 according to any of the first to seventh embodiments. Further, the insulating film 78 is formed by a mist chemical vapor deposition (MCVD: Mist Chemical Vapor Deposition) method or a mist vapor phase epitaxy (MVPE: Mist Vapor Phase Epitaxy) method. For such a deposition method, refer to Journal of the Surface Finishing Society of Japan, vol. 68 (2017), No. 12, pp. 707-711, for example. In the deposition method exemplified herein, the insulating film 78 is able to be deposited at a low temperature of 150°C or less, for example.

The insulating film 78 formed using such a deposition method is formed to have a uniform thickness on each of the first transparent electrode 61 in the effective pixel region 101, the insulator 2 in the peripheral region 102, and the first sidewall insulator 75.

In the same manner as the process illustrated in FIG. 48 of the sixth manufacturing method, the insulating film 78 formed on the first transparent electrode 61 in the effective pixel region 101 and the insulator 2 in the peripheral region 102 is removed, as illustrated in FIG. 56. For example, the dry etching method is used to remove the insulating film 78. The removal of the insulating film 78 allows the surface of the first transparent electrode 61 to be exposed in the effective pixel region 101.

At this time, due to a step difference shape of the pixel section 100, the insulating film 78 formed on the insulator 2 in the peripheral region 102 is formed to be thick, as for the thickness, at a location of the side surface of the pixel section 100, and thus a portion of the insulating film 78 remains. Further, the insulating film 78 is formed using the CVD method, and is removed using, for example, the dry etch method, thus allowing a portion of the insulating film 78 to be formed as the second sidewall insulator 76 having a curved wall surface 7C. The curved wall surface 7C is formed in a curved surface shape that extends from the first transparent electrode 61 toward the transparent semiconductor 4 and from the effective pixel region 101 to the peripheral region 102 and protrudes from the effective pixel region 101 to the peripheral region 102 in a side view. In general, the second sidewall insulator 76 is called a sidewall spacer.

When the second sidewall insulator 76 is formed, the sidewall insulator 7 including the first sidewall insulator 75 and the second sidewall insulator 76 is completed.

In the same manner as the process illustrated in FIG. 47 of the fifth manufacturing method, the second transparent electrode 62 is formed on the first transparent electrode 61 in the effective pixel region 101. When the second transparent electrode 62 is formed, the transparent electrode 6 is completed by the first transparent electrode 61 and the second transparent electrode 62 formed on the first transparent electrode 61.

Further, when the second transparent electrode 62 is formed, the wiring line 63 is formed, in the same process, extending from the second transparent electrode 62 to the coupling section 8 along the curved wall surface 7C of the sidewall insulator 7.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102 (see FIG. 42). Subsequently, the light-blocking film 10 is formed on the protective film 9 in the peripheral region 102, as illustrated in FIG. 42 mentioned above.

When the series of manufacturing process ends, the solid-state imaging device 1 according to the eighth embodiment is completed.

### [Workings and Effects]

In the solid-state imaging device 1 according to the eighth embodiment, it is possible to achieve the same workings and effects or substantially the same workings and effects as the workings and effects achieved by the solid-state imaging device 1 according to the foregoing sixth embodiment.

In addition, in the manufacturing method of the solid-state imaging device 1, the insulating film 78 is formed in a uniform thickness using the CVD method, as illustrated in FIG. 55. Subsequently, the insulating film 78 is removed using the RIE method, as illustrated in FIG. 56. As a result, the sidewall insulator 7 having the curved wall surface 7C is formed on the side surface of the pixel section 100.

It is therefore possible to further improve the step coverage of the wiring line 63 extending from the transparent electrode 6 of the pixel section 100 to the coupling section 8 along the sidewall insulator 7. That is, it is possible to effectively suppress or prevent the reduction in the cross-sectional area of the wiring line 63 and thus to reduce the resistance value. Additionally, it is possible to further effectively prevent the disconnection of the wiring line 63.

### <9. Ninth Embodiment>

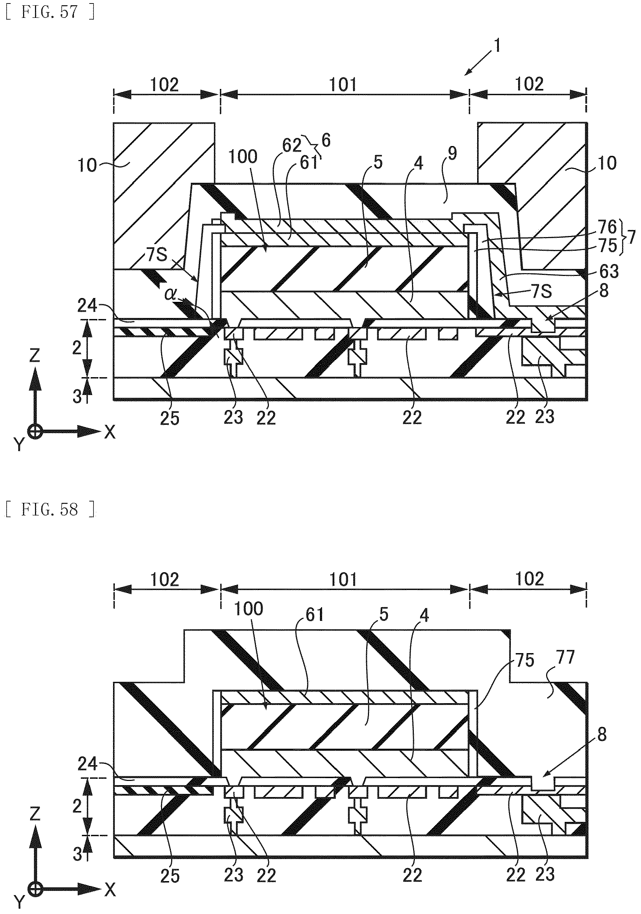

Description is given of the solid-state imaging device 1 according to a ninth embodiment of the present disclosure with reference to FIGs. 57 to 62.

### [Configuration of Solid-State Imaging Device 1]

FIG. 57 illustrates an example of a longitudinal cross-sectional configuration of the solid-state imaging device 1. In the solid-state imaging device 1 according to the ninth embodiment, the coupling section 8 is configured by a stacked structure of the wiring line 23 and the wiring line 22 stacked on the wiring line 23, as illustrated in FIG. 57. That is, the wiring line 22 is formed on the wiring line 23, instead of the insulating film 25 of the solid-state imaging device 1 according to the fifth embodiment illustrated in FIG. 42.

The wiring line 23 is formed by W, for example. The wiring line 22 is formed by, for example, ITO which is a transparent electrode material. Therefore, the coupling section 8 has a two-layered structure of the wiring line 23 and the wiring line 22, thus allowing an effective thickness of the wiring layer to be increased.

Components other than the above-described components are the same or substantially the same as the components of the solid-state imaging device 1 according to the foregoing fifth embodiment. In addition, components other than the above-described components are the same or substantially the same as the components of the solid-state imaging device 1 according to each of the first to fourth embodiments and the sixth to eighth embodiments.

### [Manufacturing Method of Solid-State Imaging Device 1]

Next, description is given of the manufacturing method of the solid-state imaging device 1 with reference to FIGs. 58 to 62 while referring to FIG. 57.

First, in a region of formation of the coupling section 8 in the peripheral region 102, the wiring line 23 and the wiring line 22 stacked on the wiring line 23 are formed inside the insulator 2 (see FIG. 57). The wiring line 22 is formed by the same process as the process of forming the wiring line 22 in the effective pixel region 101, and is formed by the same electrically-conductive material. The wiring line 22 is formed instead of the insulating film 25 illustrated in FIG. 42.

In the same manner as the process illustrated in FIGs. 6 to 8 of the first manufacturing method, the insulating film 24 of the insulator 2 is removed to form a coupling hole with no reference numeral, in the region of formation of the coupling section 8 in the peripheral region 102. At this time, a surface of the wiring line 22 on the wiring line 23 is exposed in the coupling hole.

Here, even when overetching is performed, a portion of the wiring line 22 in a thickness direction remains. In addition, even when all of the wiring line 22 in the thickness direction is removed, the wiring line 23 exists below the wiring line 22. That is, it is possible, in the coupling section 8, to sufficiently secure a working margin of the insulating film 24 in the thickness direction, thus making it possible to surely secure electrical coupling between the wiring line 23 and the wiring line 63 that is to be formed later.

In the same manner as the process illustrated in FIG. 43 of the fifth manufacturing method, the insulating film 77 is formed on the entire surface including the top of the first transparent electrode 61 in the effective pixel region 101 and the top of the insulator 2 in the peripheral region 102, as illustrated in FIG. 58.

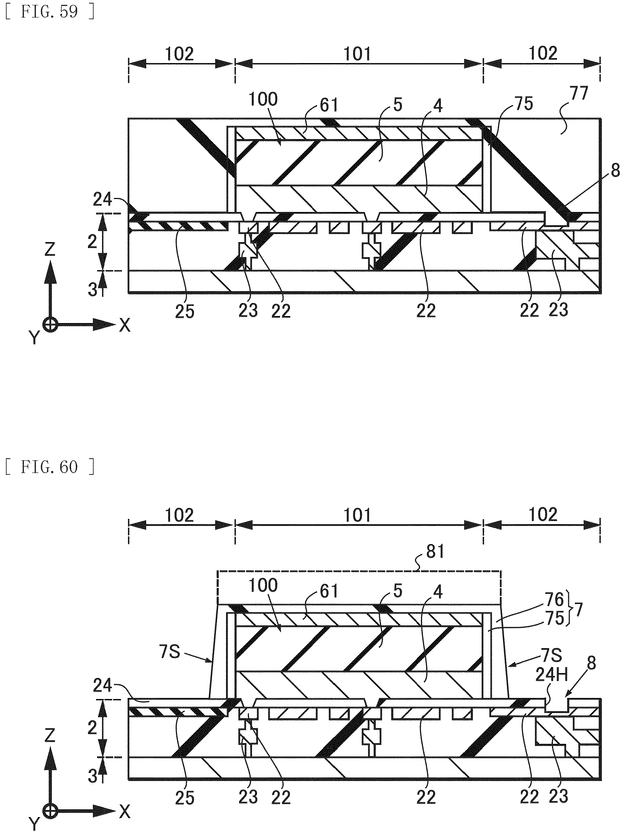

In the same manner as the process illustrated in FIG. 44 of the fifth manufacturing method, the surface of the insulating film 77 is planarized, as illustrated in FIG. 59. The CMP method or the etch-back method is used for the planarization.

In the same manner as the process illustrated in FIG. 45 of the fifth manufacturing method, the mask 81 is formed on the insulating film 77 in the effective pixel region 101, and the mask 81 is used to remove the insulating film 77 in the peripheral region 102, as illustrated in FIG. 60. When the insulating film 77 is removed, the second sidewall insulator 76 having the inclined wall surface 7S is formed from the insulating film 77.

Thus, the sidewall insulator 7 is completed by the first sidewall insulator 75 formed in advance on the side surface of the pixel section 100 and the second sidewall insulator 76 newly formed on the first sidewall insulator 75.

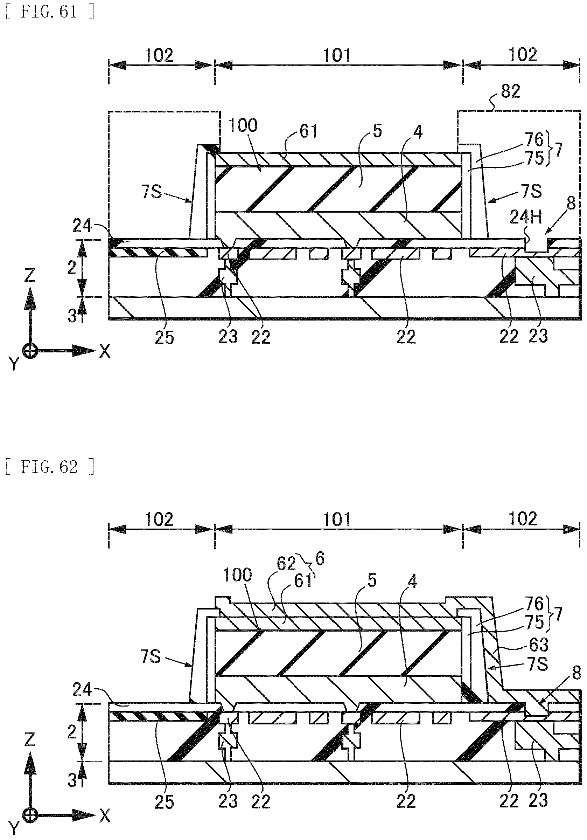

In the same manner as the process illustrated in FIG. 46 of the fifth manufacturing method, the mask 82 is formed that covers the top of the insulator 2 and the top of the sidewall insulator 7 in the peripheral region 102, and the mask 82 is used to remove the insulating film 77 remaining on the first transparent electrode 61 in the effective pixel region 101, as illustrated in FIG. 61. For example, the dry etching method is used to remove the insulating film 77. The removal of the insulating film 77 allows the surface of the first transparent electrode 61 to be exposed. The mask 82 is then removed.

In the same manner as the process illustrated in FIG. 47 of the fifth manufacturing method, the second transparent electrode 62 is formed on the first transparent electrode 61 in the effective pixel region 101, as illustrated in FIG. 62. When the second transparent electrode 62 is formed, the transparent electrode 6 is completed by the first transparent electrode 61 and the second transparent electrode 62 formed on the first transparent electrode 61.

Further, when the second transparent electrode 62 is formed, the wiring line 63 is formed, in the same process, extending from the second transparent electrode 62 to the coupling section 8 along the inclined wall surface 7S of the sidewall insulator 7. In the coupling section 8, the wiring line 63 is surely electrically coupled to the wiring line 23 through the wiring line 22 inside the insulator 2.

In the same manner as the process illustrated in FIG. 14 of the first manufacturing method, the protective film 9 is formed on the entire surface including the top of the transparent electrode 6 in the effective pixel region 101, the top of the wiring line 63 in the peripheral region 102, and the top of the coupling section 8 in the peripheral region 102 (see FIG. 57). Subsequently, the light-blocking film 10 is formed on the protective film 9 in the peripheral region 102, as illustrated in FIG. 57 mentioned above.

When the series of manufacturing process ends, the solid-state imaging device 1 according to the ninth embodiment is completed.

### [Workings and Effects]

In the solid-state imaging device 1 according to the ninth embodiment, it is possible to achieve the same workings and effects or substantially the same workings and effects as the workings and effects achieved by the solid-state imaging device 1 according to the foregoing fifth embodiment.

In addition, in the solid-state imaging device 1, the coupling section 8 in the peripheral region 102 is formed by the two-layered structure in which the wiring line 22 is stacked on the wiring line 23, as illustrated in FIG. 57.

Therefore, as illustrated in FIGs. 6 to 8 of the first manufacturing method, when the coupling hole is formed in the insulating film 24, an allowable amount of overetching corresponding to the thickness of the wiring line 22 is generated, thus making it possible to improve the working margin. Further, it is possible to surely electrically couple the wiring line 63 and the wiring line 23 to each other.

### <10. Tenth Embodiment>

Description is given of the solid-state imaging device 1 according to the tenth embodiment of the present disclosure with reference to FIGs. 63 to 73.

### [Configuration of Solid-State Imaging Device 1]

FIG. 63 illustrates an example of a longitudinal cross-sectional configuration of the solid-state imaging device 1. FIG. 64 illustrates an example of a planar configuration of the solid-state imaging device 1.

As illustrated in FIG. 63, the solid-state imaging device 1 according to the tenth embodiment includes, in the effective pixel region 101, the pixel section 100 in which the transparent semiconductor 4, the organic photoelectric conversion film 5, and the transparent electrode 6 are each sequentially stacked, in the same manner as the solid-state imaging device 1 according to the first embodiment. The transparent electrode 6, in this example, is formed by a monolayer structure. It is to be noted that the transparent electrode 6 may have a stacked structure of the first transparent electrode 61 and the second transparent electrode 62, in the same manner as the transparent electrode 6 of the solid-state imaging device 1 according to any of the first to ninth embodiments.

The transparent electrode 6 is coupled to a wiring line 65 through a transparent coupling section 64 at an end of the effective pixel region 101. The transparent coupling section 64 is formed on the transparent electrode 6, and is electrically coupled to the transparent electrode 6. The wiring line 65 is formed on the transparent coupling section 64, and is electrically coupled to the transparent coupling section 64. The wiring line 65, in this example, is integrally formed with the transparent coupling section 64.

In the tenth embodiment, the transparent coupling section 64 is disposed at two ends, of the effective pixel region 101, opposed to each other in the arrow-X direction in a plan view. Each transparent coupling section 64 is formed in a rectangular shape elongated in the arrow-Y direction. The transparent coupling section 64 is formed by the same transparent electrode material as that of the transparent electrode 6. The transparent coupling section 64 is formed by IZO, for example.

Further, the coupling section 8 is disposed at two locations, of the peripheral region 102, opposed to each other in the arrow-X direction in a plan view. In the same manner as the transparent coupling section 64, each coupling section 8 is formed in a rectangular shape elongated in the arrow-Y direction, and extends in parallel to the extending direction of the transparent coupling section 64.

The wiring line 65 has one end coupled to the transparent coupling section 64 and the other end extending along the side surface of the pixel section 100 to be coupled to the coupling section 8. The wiring line 65 is electrically coupled to the wiring line 23 at the coupling section 8. The wiring line 65 is extended and spaced apart from the side surface of the pixel section 100 with the protective film 9 interposed therebetween, and is electrically separated from the transparent semiconductor 4.

In the tenth embodiment, the wiring line 65 is formed by the same transparent electrode material as that of the transparent electrode 6, in the same manner as the transparent coupling section 64.

Further, the protective film 9 is formed on the transparent electrode 6, the transparent coupling section 64, and the wiring line 65 in the effective pixel region 101, and the protective film 9 is also formed on the insulator 2 and the wiring line 65 in the peripheral region 102. The protective film 9, in this example, is formed by a first protective film 9A and a second protective film 9B. The first protective film 9A is formed on the transparent electrode 6, and is formed between the transparent electrode 6 and the wiring line 65. The second protective film 9B is formed on the wiring line 65 and on the first protective film 9A.

Further, in the peripheral region 102, the light-blocking film 10 is formed on the protective film 9.

Here, the light-blocking film 10 is formed by a light-blocking material having a lower stress than that of the protective film 9. Specifically, the light-blocking film 10 is formed by, for example, a light-blocking material having a stress that can be reduced to a stress of 50 MPa or less, which is lower than that of W that causes a stress of 100 MPa to 300 MPa. For example, aluminum (Al) having a low stress of 30 MPa to 50 MPa is used as the light-blocking film 10. In this case, the light-blocking film 10 is formed to have a thickness of 50 nm or more and 200 nm or less, for example.

When a light-blocking material having a low stress is used as the light-blocking film 10, it is possible to effectively suppress an influence of the stress from the light-blocking film 10 on the pixel section 100, thus making it possible to reduce the thickness of the protective film 9. The protective film 9 can be formed to have a thickness of 200 nm or more and 1000 nm or less, for example.

Components other than the above-described components are the same or substantially the same as the components of the solid-state imaging device 1 according to the foregoing first embodiment.

### [Manufacturing Method of Solid-State Imaging Device 1]

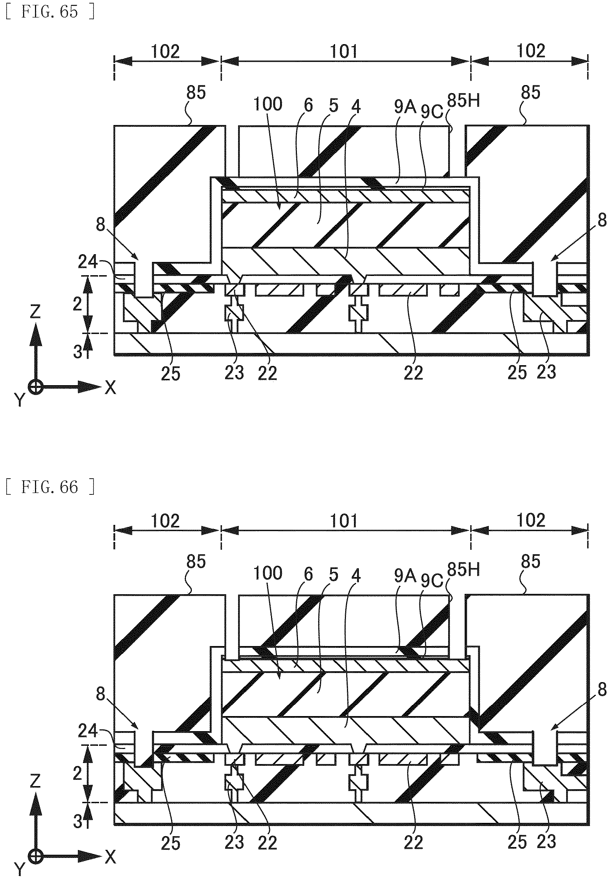

Next, description is given of the manufacturing method of the solid-state imaging device 1 with reference to FIGs. 65 to 73 while referring to FIGs. 63 and 64.

First, in the same manner as the process illustrated in FIG. 3 of the first manufacturing method, the transparent semiconductor 4, the organic photoelectric conversion film 5, and the transparent electrode 6 are each sequentially formed on the insulator 2 in the effective pixel region 101. It is to be noted that, in the effective pixel region 101, a hard mask 9C is formed on the transparent electrode 6 (see FIG. 65). The hard mask 9C is formed by, for example, AlO, SiO₂, or the like, and is formed to have a thickness of 20 nm or more and 100 nm or less, for example.

Thereafter, the first protective film 9A of the protective film 9 is formed on the entire surface including the top of the hard mask 9C in the effective pixel region 101 and the top of the insulator 2 in the peripheral region 102 (see FIG. 65).

In the same manner as the process illustrated in FIGs. 6 to 8 of the first manufacturing method, a portion of the insulator 2 is removed to form the coupling section 8 in which the surface of the wiring line 23 is exposed, in the peripheral region 102 (see FIG. 65).

As illustrated in FIG. 65, a mask 85 is formed on the entire surface including the top of the first protective film 9A in the effective pixel region 101 and the top of the first protective film 9A in the peripheral region 102. The mask 85 is formed by a photoresist, for example. In a region of formation of the transparent coupling section 64, an opening 85H is formed in the mask 85.

As illustrated in FIG. 66, in the effective pixel region 101, the first protective film 9A and the hard mask 9C exposed from the opening 85H are removed using the mask 85 to form a coupling hole with no reference numeral. When the coupling hole is formed, a surface of the transparent electrode 6 is exposed in the coupling hole.

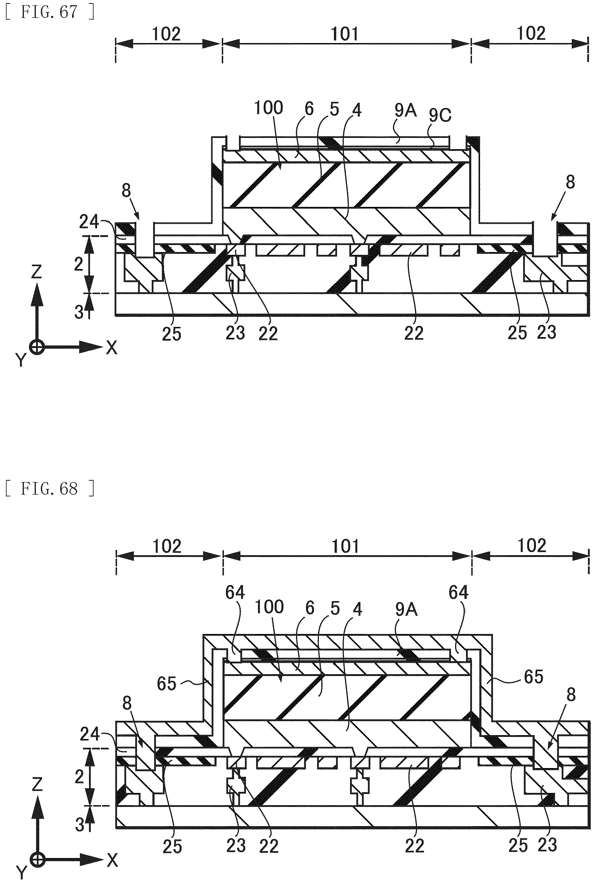

As illustrated in FIG. 67, the mask 85 is removed. When the mask 85 is removed, the surface of the wiring line 23 is exposed in the coupling section 8 in the peripheral region 102.

As illustrated in FIG. 68, the wiring line 65 is formed on the entire surface on the first protective film 9A in a region including the effective pixel region 101 and the peripheral region 102. The wiring line 65 is electrically coupled to the surface of the transparent electrode 6 through the coupling hole formed in the first protective film 9A in the effective pixel region 101. In addition, the wiring line 65 is electrically coupled to the surface of the wiring line 23 at the coupling section 8 in the peripheral region 102.

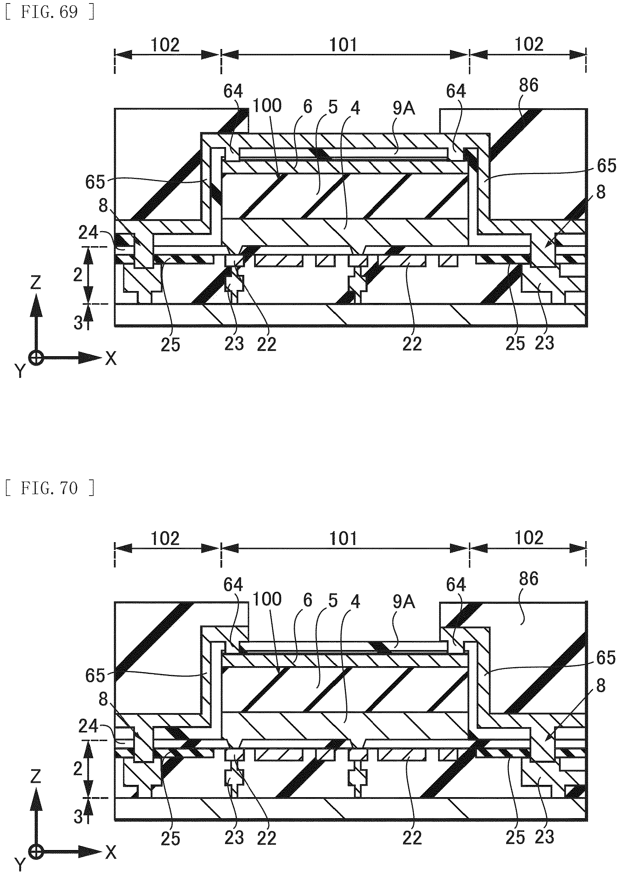

As illustrated in FIG. 69, a mask 86 is formed on the wiring line 65. The mask 86 is formed by a photoresist, for example.

As illustrated in FIG. 70, the mask 86 is used to pattern the wiring line 65 and remove the wiring line 65 in an unnecessary region, thus forming the transparent coupling section 64 and the wiring line 65 extending from the transparent coupling section 64 to the coupling section 8. That is, the transparent coupling section 64 and the wiring line 65, in this example, are formed by the same process and by the same transparent electrode material.

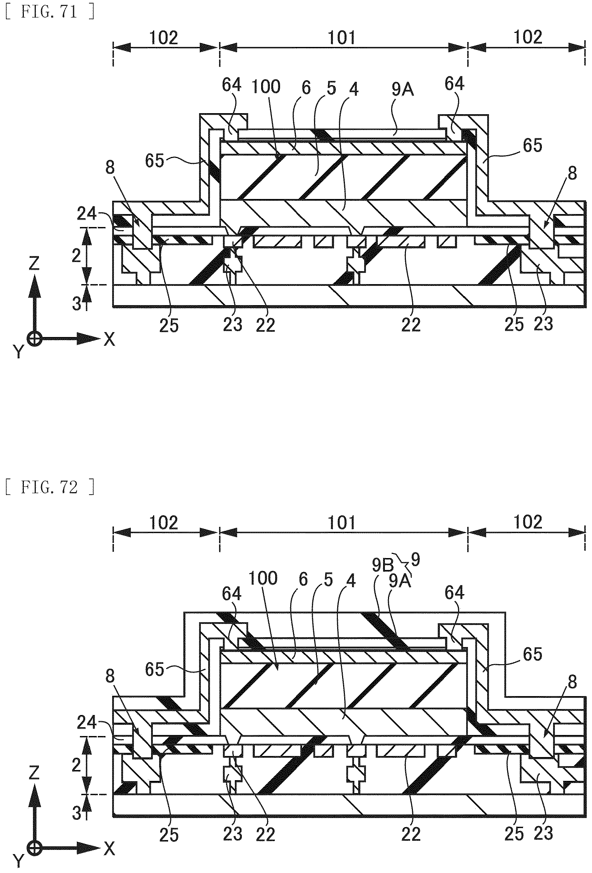

Thereafter, the mask 86 is removed as illustrated in FIG. 71.

As illustrated in FIG. 72, the second protective film 9B is formed on the wiring line 65 and on the entire surface of the first protective film 9A. When the second protective film 9B is formed, the protective film 9 formed by the first protective film 9A and the second protective film 9B is completed. It is to be noted that, in the tenth embodiment, the hard mask 9C is left as a portion of the protective film 9.

Here, the protective film 9 is made to be a thinner film because the light-blocking film 10 formed thereafter is formed by a light-blocking material having a lower stress.

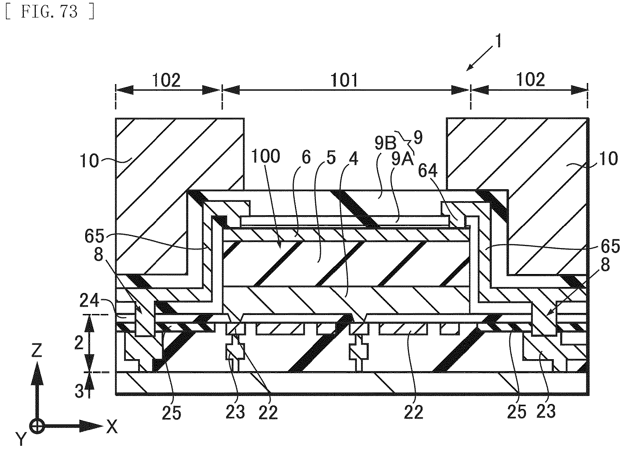

As illustrated in FIG. 73, the light-blocking film 10 is formed on the protective film 9 in the peripheral region 102. As described above, the light-blocking film 10 is formed by Al as a light-blocking material having a low stress, for example.

Thereafter, as illustrated in FIG. 63 mentioned above, a protective film with no reference numeral is formed on a surface of the light-blocking film 10.

When the series of manufacturing process ends, the solid-state imaging device 1 according to the tenth embodiment is completed.

### [Workings and Effects]

In the solid-state imaging device 1 according to the tenth embodiment, the light-blocking film 10 on the protective film 9 is formed by a light-blocking material having a low stress in the peripheral region 102, as illustrated in FIG. 63. This effectively suppresses or prevents a stress on the pixel section 100 from the light-blocking film 10, which makes it possible to make the thickness of the protective film 9 thinner, thus making it possible to achieve a reduction in the height of the protective film 9.

In the effective pixel region 101, a color filter, an optical lens, and the like, which are unillustrated, are disposed on the pixel section 100; achieving the reduction in the height of the protective film 9 makes it possible to improve RGB oblique-incidence characteristics.

In addition, in the solid-state imaging device 1, the light-blocking film 10 is formed by a light-blocking material having a low stress of 50 MPa or less, and the light-blocking film 10 is formed by Al, for example. This makes it possible to reduce the height of the protective film 9 to a thickness of 1000 nm or less.

### [Modification Example 1]

Although illustration is omitted, in the solid-state imaging device 1 according to a first modification example of the tenth embodiment, the transparent coupling section 64 and the wiring line 65 are each formed by a transparent electrode material different from that of the transparent electrode 6 of the pixel section 100 (see FIG. 63).

For example, when the transparent electrode 6 is formed by IZO, the transparent coupling section 64 and the wiring line 65 are each formed by the transparent electrode material exemplified for the solid-state imaging device 1 according to the first embodiment. Specifically, the transparent coupling section 64 and the wiring line 65 are each formed using one or more transparent electrode materials selected from ITO, SnOx, ZnOx, TiOx and Ag nanowires.

Components other than the above-described components are the same or substantially the same as the components of the solid-state imaging device 1 according to the foregoing tenth embodiment.

### [Modification Example 2]

Although illustration is omitted, in the solid-state imaging device 1 according to a second modification example of the tenth embodiment, the transparent coupling section 64 is disposed at two ends, of the effective pixel region 101, opposed to each other in the arrow-Y direction in a plan view (see FIG. 64). Each transparent coupling section 64 is formed in a rectangular shape elongated in the arrow-X direction. The transparent coupling section 64 is formed by the same transparent electrode material as that of the transparent electrode 6, in the same manner as the solid-state imaging device 1 illustrated in FIG. 63. In addition, the transparent coupling section 64 may be formed by a transparent electrode material different from that of the transparent electrode 6, as described in the modification example 1.

Further, the coupling section 8 is disposed at two locations, of the peripheral region 102, opposed to each other in the arrow-Y direction in a plan view. In the same manner as the transparent coupling section 64, each coupling section 8 is formed in a rectangular shape elongated in the arrow-X direction, and extends in parallel to the extending direction of the transparent coupling section 64.

Components other than the above-described components are the same or substantially the same as the components of the solid-state imaging device 1 according to the foregoing tenth embodiment.

In addition, in the solid-state imaging device 1 according to a modification example 2, the transparent coupling section 64 may be disposed at one end of the effective pixel region 101 in the arrow-Y direction in a plan view. Likewise, the coupling section 8 may be disposed at one end of the peripheral region 102 in the arrow-Y direction.

Further, in the solid-state imaging device 1 according to the modification example 2, the transparent coupling section 64 may be disposed at a total of four ends of two ends, of the effective pixel region 101, opposed to each other in the arrow-X direction and two ends opposed to each other in the arrow-Y direction in a plan view. Likewise, the coupling section 8 may be disposed at a total of four ends of two ends, of the peripheral region 102, opposed to each other in the arrow-X direction and two ends opposed to each other in the arrow-Y direction in a plan view.

### <11. Eleventh Embodiment>

Description is given of the solid-state imaging device 1 according to an eleventh embodiment of the present disclosure with reference to FIG. 74. As for the solid-state imaging device 1 according to the eleventh embodiment to a fifteenth embodiment, description is given of a schematic structure to which the present technology is applicable.

### [Configuration of Solid-State Imaging Device 1]

FIG. 74 illustrates a schematic example of a longitudinal cross-sectional configuration of the solid-state imaging device 1.

In the solid-state imaging device 1 according to the eleventh embodiment, the transparent semiconductor 4 including an oxide semiconductor typified by IGZO serves as a carrier accumulation layer and as a transfer layer, and the transparent semiconductor 4 is used to drive the organic photoelectric conversion film 5.

In the solid-state imaging device 1, the insulator 2, in which infrared-transmission filters are formed, for example, as a visible light transmission filter, is disposed on the base body 3 in which photodiodes 31 are disposed, as illustrated in FIG. 74. The photodiodes are formed in a silicone semiconductor layer for each pixel. The infrared-transmission filters are arranged to correspond to the photodiodes, and are formed for each pixel.

The transparent semiconductor 4 is disposed on the insulator 2, and the organic photoelectric conversion film 5 is disposed on the transparent semiconductor 4. Here, a panchromatic (Panchromatic) organic photoelectric conversion film adaptable to almost all of visible light beams from ultraviolet light to infrared light is used as the organic photoelectric conversion film 5.

A color filter 11 is disposed on the organic photoelectric conversion film 5. Here, the color filter 11 includes a red light color filter 11R, a blue light color filter 11B, and a green light color filter 11G. These filters are arranged to correspond to the arrangement positions of the photodiodes 31.

The solid-state imaging device 1 according to any of the foregoing first to tenth embodiments is applied to the solid-state imaging device 1 according to the eleventh embodiment. It is therefore possible, in the solid-state imaging device 1 according to the eleventh embodiment, to achieve the same or substantially the same workings and effects as the workings and effects achieved by the solid-state imaging device 1 according to any of the first to tenth embodiments.

### <12. Twelfth Embodiment>

Description is given of the solid-state imaging device 1 according to the twelfth embodiment of the present disclosure with reference to FIG. 75.

### [Configuration of Solid-State Imaging Device 1]

FIG. 75 illustrates a schematic example of a longitudinal cross-sectional configuration of the solid-state imaging device 1.

In the solid-state imaging device 1 according to the twelfth embodiment, the insulator 2 in which the color filter 11 is formed is disposed on the base body 3 in which the photodiodes 31 are disposed. The color filter 11 includes the red light color filter 11R and the blue light color filter 11B.

Further, the transparent semiconductor 4 is disposed on the insulator 2, and the organic photoelectric conversion film 5 is disposed on the transparent semiconductor 4. Here, a green organic photoelectric conversion film 5G is used as the organic photoelectric conversion film 5.

The solid-state imaging device 1 according to any of the foregoing first to tenth embodiments is applied to the solid-state imaging device 1 according to the twelfth embodiment. It is therefore possible, in the solid-state imaging device 1 according to the twelfth embodiment, to achieve the same or substantially the same workings and effects as the workings and effects achieved by the solid-state imaging device 1 according to any of the first to tenth embodiments.

### <13. Thirteenth Embodiment>

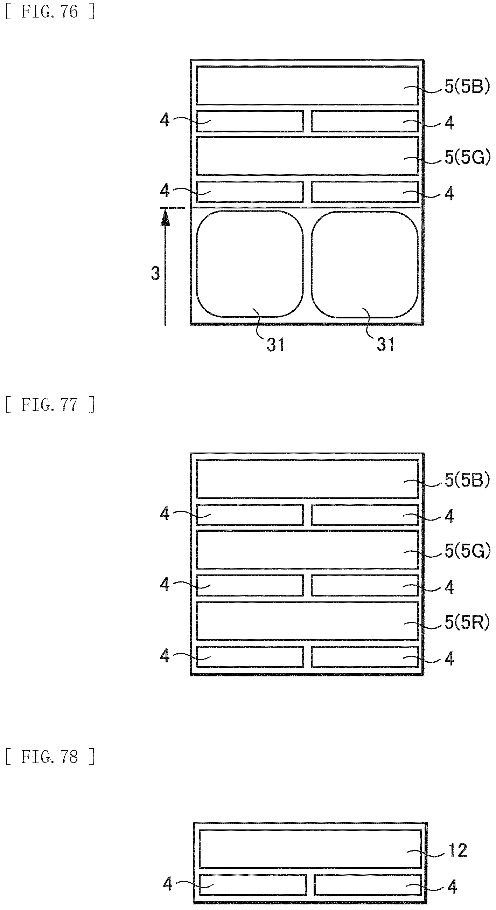

Description is given of the solid-state imaging device 1 according to the thirteenth embodiment of the present disclosure with reference to FIG. 76.

### [Configuration of Solid-State Imaging Device 1]

FIG. 76 illustrates a schematic example of a longitudinal cross-sectional configuration of the solid-state imaging device 1.

In the solid-state imaging device 1 according to the thirteenth embodiment, the transparent semiconductor 4 and the organic photoelectric conversion film 5 are each sequentially stacked and disposed on the base body 3 in which the photodiodes 31 are disposed. Here, the green organic photoelectric conversion film 5G is used as the organic photoelectric conversion film 5.

Further, the transparent semiconductor 4 and the organic photoelectric conversion film 5 are each sequentially stacked and disposed on the organic photoelectric conversion film 5. Here, a blue organic photoelectric conversion film 5B is used as the organic photoelectric conversion film 5.

The solid-state imaging device 1 according to any of the foregoing first to tenth embodiments is applied to the solid-state imaging device 1 according to the thirteenth embodiment. It is therefore possible, in the solid-state imaging device 1 according to the thirteenth embodiment, to achieve the same or substantially the same workings and effects as the workings and effects achieved by the solid-state imaging device 1 according to any of the first to tenth embodiments.

### <14. Fourteenth Embodiment>

Description is given of the solid-state imaging device 1 according to the fourteenth embodiment of the present disclosure with reference to FIG. 77.

### [Configuration of Solid-State Imaging Device 1]

FIG. 77 illustrates a schematic example of a longitudinal cross-sectional configuration of the solid-state imaging device 1.

In the solid-state imaging device 1 according to the fourteenth embodiment, a plurality of transparent semiconductors 4 and a plurality of organic photoelectric conversion films 5 are alternately stacked.

Here, a red organic photoelectric conversion film 5R is used as the organic photoelectric conversion film 5 of the lowermost layer. The green organic photoelectric conversion film 5G is used as the organic photoelectric conversion film 5 of the interlayer. Further, the blue organic photoelectric conversion film 5B is used as the organic photoelectric conversion film 5 of the uppermost layer.

The solid-state imaging device 1 according to any of the foregoing first to tenth embodiments is applied to the solid-state imaging device 1 according to the fourteenth embodiment. It is therefore possible, in the solid-state imaging device 1 according to the fourteenth embodiment, to achieve the same or substantially the same workings and effects as the workings and effects achieved by the solid-state imaging device 1 according to any of the first to tenth embodiments.

### <15. Fifteenth Embodiment>

Description is given of the solid-state imaging device 1 according to the fourteenth embodiment of the present disclosure with reference to FIG. 78.

### [Configuration of Solid-State Imaging Device 1]

FIG. 78 illustrates a schematic example of a longitudinal cross-sectional configuration of the solid-state imaging device 1.

In the solid-state imaging device 1 according to the fifteenth embodiment, a near-infrared light quantum dot (NIR-QD: Near-Infrared Light emitting Quantum Dot) 12 is disposed on the transparent semiconductor 4.

The solid-state imaging device 1 according to any of the foregoing first to tenth embodiments is applied to the solid-state imaging device 1 according to the fifteenth embodiment. It is therefore possible, in the solid-state imaging device 1 according to the fifteenth embodiment, to achieve the same or substantially the same workings and effects as the workings and effects achieved by the solid-state imaging device 1 according to any of the first to tenth embodiments.

### <16. Other Embodiments>

The present technology is not limited to the embodiments described above, and various modifications may be made without departing from the gist of the present technology.

For example, a solid-state imaging device may be constructed in which the solid-state imaging devices according to two or more embodiments are combined among the solid-state imaging devices according to the foregoing first to fifteenth embodiments.

In addition, in the present technology, an organic or inorganic perovskite can be used instead of the NIR-QD of the solid-state imaging device according to the foregoing fifteenth embodiment. Further, the photodiode is not limited to Si, and may be a compound semiconductor.

In the present disclosure, the solid-state imaging device includes a pixel section including a transparent semiconductor, an organic photoelectric conversion film and a transparent electrode, a coupling section, and a wiring line.

The transparent semiconductor is formed in an effective pixel region of an insulator. The organic photoelectric conversion film is formed on the transparent semiconductor on a side opposite to the insulator. The transparent electrode is formed on the organic photoelectric conversion film on a side opposite to the transparent semiconductor. The coupling section is disposed in the insulator in a peripheral region around the effective pixel region, and is coupled to a circuit that supplies electricity to the transparent electrode.

Here, the wiring line electrically couples the transparent electrode and the coupling section to each other, and is formed by a transparent electrode material. Therefore, the wiring line is formed by extending at least a portion of the transparent electrode, thus enabling the wiring line to directly couple the transparent electrode and the coupling section to each other. That is, there is no need to form a coupling hole in a protective film on the transparent electrode and in the protective film on the coupling section, and there is no need to route the wiring line in the coupling hole and on the protective film. This simplifies a wiring structure for coupling the transparent electrode and the coupling section to each other.

In addition, the wiring line is not routed, and thus a wiring line length of the wiring line is shortened, thus making it possible to reduce a wiring resistance of the wiring line.

### <Configuration of Present Technology>

The present technology includes the following configurations. Providing the following configurations enables the solid-state imaging device to have a simplified wiring structure and to have a reduced wiring resistance of the wiring line.

## Claims

1. A solid-state imaging device (1) comprising:
a pixel section (100) that includes
a transparent semiconductor (4) formed in an effective pixel region (101) of an insulator (2), the transparent semiconductor (4) being transparent in a visible light range;
an organic photoelectric conversion film (5) formed on the transparent semiconductor (4) on a side opposite to the insulator (2), and
a transparent electrode (6) formed on the organic photoelectric conversion film (5) on a side opposite to the transparent semiconductor (4), the transparent electrode (6) being transparent in the visible light range;
a coupling section (8) disposed in the insulator (2) in a peripheral region (102) around the effective pixel region (101), the coupling section (8) being coupled to a circuit that supplies electricity to the transparent electrode (6);
a wiring line (63) that electrically couples the transparent electrode (6) and the coupling section (8) to each other, and is formed by a transparent electrode material,
**characterised in that**
the transparent electrode (6) includes a first transparent electrode (61) formed on the organic photoelectric conversion film (5), and a second transparent electrode (62) formed on the first transparent electrode (61) on a side opposite to the organic photoelectric conversion film (5), the wiring line (63) being formed in same electrically-conductive layer as at least a portion of the transparent electrode (6).

2. The solid-state imaging device (1) according to claim 1, wherein a thickness of the wiring line (63) is thinner than a thickness of the transparent electrode (6).

3. The solid-state imaging device (1) according to any of the preceding claims, comprising a sidewall insulator (7) on a side surface of the organic photoelectric conversion film (5) and on a side surface of the transparent semiconductor (4), wherein
the wiring line (63) extends from the transparent electrode (6) to the coupling section (8) along the side surface of the organic photoelectric conversion film (5) and the side surface of the transparent semiconductor (4), with the sidewall insulator (7) being interposed therebetween.

4. The solid-state imaging device (1) according to any of claims 1 to 3, wherein
the side surface of the transparent semiconductor (4) is formed inside the side surface of the organic photoelectric conversion film (5) in the effective pixel region (101), and
a cavity (4S) is formed between the side surface of the transparent semiconductor (4) and the wiring line (63).

5. The solid-state imaging device (1) according to any of the preceding claims, wherein
a protective film (9) that covers the transparent electrode (6) and the wiring line (63) is formed in the effective pixel region (101) and the peripheral region (102), and
a light-blocking film (10) that blocks light is formed on the protective film (9) on a side opposite to the wiring line in the peripheral region (102).

6. The solid-state imaging device (1) according to claim 5, comprising a sidewall insulator (7) on a side surface of the organic photoelectric conversion film (5) and on a side surface of the transparent semiconductor (4), wherein
the wiring line (63) extends from the transparent electrode (6) to the coupling section (8) along the side surface of the organic photoelectric conversion film (5) and the side surface of the transparent semiconductor (4), with the sidewall insulator (7) being interposed therebetween, and
the sidewall insulator (7) extends between the insulator (2) and the protective film (9) in the peripheral region (102).

7. The solid-state imaging device (1) according to claim 3 or 6, wherein the sidewall insulator (7) has an inclined wall surface extending from the transparent electrode (6) toward the transparent semiconductor (4) and from the effective pixel region (101) to the peripheral region (102).

8. The solid-state imaging device (1) according to claim 7, wherein an inclination angle, on a side of the effective pixel region (101), formed between the inclined wall surface and a surface of the insulator (2) is 20 degrees or more and less than 90 degrees.

9. The solid-state imaging device (1) according to claim 3 or 6, wherein the sidewall insulator (7) has a curved wall surface extending from the transparent electrode (6) toward the transparent semiconductor (4) and from the effective pixel region (101) to the peripheral region (102), the curved wall surface protruding from the effective pixel region (101) to the peripheral region (102).

10. The solid-state imaging device (1) according to claim 3 or 6, wherein a thickness of the sidewall insulator (7), formed on the side surface of the organic photoelectric conversion film (5), from the side surface of organic photoelectric conversion film (5) is thicker than a thickness of the sidewall insulator (5), formed on the side surface of the transparent electrode (6), from the side surface of the transparent electrode (6).

11. The solid-state imaging device (1) according to any of the preceding claims, wherein the wiring line (63) is formed by same transparent electrode material as the transparent electrode (6) or by a transparent electrode material different therefrom.

12. The solid-state imaging device (1) according to claim 5 or 6, wherein the light-blocking film (10) is a film having a lower stress than the protective film (9).

## Patentansprüche

1. Festkörperbildgebungsvorrichtung (1), umfassend:
einen Pixelabschnitt (100), der einschließt
einen transparenten Halbleiter (4), der in einem effektiven Pixelbereich (101) eines Isolators (2) ausgebildet ist, wobei der transparente Halbleiter (4) in einem sichtbaren Lichtbereich transparent ist;
einen organischen photoelektrischen Umwandlungsfilm (5), der auf dem transparenten Halbleiter (4) auf einer dem Isolator (2) gegenüberliegenden Seite ausgebildet ist, und
eine transparente Elektrode (6), die auf dem organischen photoelektrischen Umwandlungsfilm (5) auf einer dem transparenten Halbleiter (4) gegenüberliegenden Seite ausgebildet ist, wobei die transparente Elektrode (6) in dem sichtbaren Lichtbereich transparent ist;
einen Kopplungsabschnitt (8), der in dem Isolator (2) in einem Randbereich (102) um den effektiven Pixelbereich (101) angeordnet ist, wobei der Kopplungsabschnitt (8) an eine Schaltung gekoppelt ist, die der transparenten Elektrode (6) Elektrizität zuführt;
eine Verdrahtungsleitung (63), die die transparente Elektrode (6) und den Kopplungsabschnitt (8) elektrisch miteinander koppelt und aus einem transparenten Elektrodenmaterial gebildet ist, **dadurch gekennzeichnet, dass**
die transparente Elektrode (6) eine erste transparente Elektrode (61), die auf dem organischen photoelektrischen Umwandlungsfilm (5) ausgebildet ist, und eine zweite transparente Elektrode (62) einschließt, die auf der ersten transparenten Elektrode (61) auf einer dem organischen photoelektrischen Umwandlungsfilm (5) gegenüberliegenden Seite ausgebildet ist, wobei die Verdrahtungsleitung (63) in derselben elektrisch leitfähigen Schicht wie mindestens ein Abschnitt der transparenten Elektrode (6) ausgebildet ist.

2. Festkörperbildgebungsvorrichtung (1) nach Anspruch 1, wobei eine Dicke der Verdrahtungsleitung (63) geringer ist als eine Dicke der transparenten Elektrode (6).

3. Festkörperbildgebungsvorrichtung (1) nach einem der vorstehenden Ansprüche, umfassend einen Seitenwandisolator (7) auf einer Seitenoberfläche des organischen photoelektrischen Umwandlungsfilms (5) und auf einer Seitenoberfläche des transparenten Halbleiters (4), wobei
die Verdrahtungsleitung (63) sich von der transparenten Elektrode (6) zu dem Kopplungsabschnitt (8) entlang der Seitenoberfläche des organischen photoelektrischen Umwandlungsfilms (5) und der Seitenoberfläche des transparenten Halbleiters (4) erstreckt, wobei der Seitenwandisolator (7) dazwischen angeordnet ist.

4. Festkörperbildgebungsvorrichtung (1) nach einem der Ansprüche 1 bis 3, wobei
die Seitenoberfläche des transparenten Halbleiters (4) innerhalb der Seitenoberfläche des organischen photoelektrischen Umwandlungsfilms (5) in dem effektiven Pixelbereich (101) ausgebildet ist, und
ein Hohlraum (4S) zwischen der Seitenoberfläche des transparenten Halbleiters (4) und der Verdrahtungsleitung (63) ausgebildet ist.

5. Festkörperbildgebungsvorrichtung (1) nach einem der vorstehenden Ansprüche, wobei
ein Schutzfilm (9), der die transparente Elektrode (6) und die Verdrahtungsleitung (63) bedeckt, in dem effektiven Pixelbereich (101) und dem Randbereich (102) ausgebildet ist, und
ein lichtblockierender Film (10), der Licht blockiert, auf dem Schutzfilm (9) auf einer der Verdrahtungsleitung gegenüberliegenden Seite in dem Randbereich (102) ausgebildet ist.

6. Festkörperbildgebungsvorrichtung (1) nach Anspruch 5, umfassend einen Seitenwandisolator (7) an einer Seitenoberfläche des organischen photoelektrischen Umwandlungsfilms (5) und an einer Seitenoberfläche des transparenten Halbleiters (4), wobei
die Verdrahtungsleitung (63) sich von der transparenten Elektrode (6) zu dem Kopplungsabschnitt (8) entlang der Seitenoberfläche des organischen photoelektrischen Umwandlungsfilms (5) und der Seitenoberfläche des transparenten Halbleiters (4) erstreckt, wobei der Seitenwandisolator (7) dazwischen angeordnet ist, und
der Seitenwandisolator (7) sich zwischen dem Isolator (2) und dem Schutzfilm (9) in dem Randbereich (102) erstreckt.

7. Festkörperbildgebungsvorrichtung (1) nach Anspruch 3 oder 6, wobei der Seitenwandisolator (7) eine geneigte Wandoberfläche aufweist, die sich von der transparenten Elektrode (6) in Richtung des transparenten Halbleiters (4) und von dem effektiven Pixelbereich (101) zu dem Randbereich (102) erstreckt.

8. Festkörperbildgebungsvorrichtung (1) nach Anspruch 7, wobei ein Neigungswinkel auf einer Seite des effektiven Pixelbereichs (101), der zwischen der geneigten Wandoberfläche und einer Oberfläche des Isolators (2) gebildet ist, 20 Grad oder mehr und weniger als 90 Grad beträgt.

9. Festkörperbildgebungsvorrichtung (1) nach Anspruch 3 oder 6, wobei der Seitenwandisolator (7) eine gekrümmte Wandoberfläche aufweist, die sich von der transparenten Elektrode (6) in Richtung des transparenten Halbleiters (4) und von dem effektiven Pixelbereich (101) zu dem Randbereich (102) erstreckt, wobei die gekrümmte Wandoberfläche von dem effektiven Pixelbereich (101) zu dem Randbereich (102) hervorsteht.

10. Festkörperbildgebungsvorrichtung (1) nach Anspruch 3 oder 6, wobei eine Dicke des Seitenwandisolators (7), der auf der Seitenoberfläche des organischen photoelektrischen Umwandlungsfilms (5) ausgebildet ist, von der Seitenoberfläche des organischen photoelektrischen Umwandlungsfilms (5) dicker ist als eine Dicke des Seitenwandisolators (5), der auf der Seitenoberfläche der transparenten Elektrode (6) ausgebildet ist, von der Seitenoberfläche der transparenten Elektrode (6).

11. Festkörperbildgebungsvorrichtung (1) nach einem der vorstehenden Ansprüche, wobei die Verdrahtungsleitung (63) aus demselben transparenten Elektrodenmaterial wie die transparente Elektrode (6) oder aus einem davon verschiedenen transparenten Elektrodenmaterial gebildet ist.

12. Festkörperbildgebungsvorrichtung (1) nach Anspruch 5 oder 6, wobei der lichtblockierende Film (10) ein Film mit einer geringeren Spannung als der Schutzfilm (9) ist.

## Revendications

1. Dispositif d'imagerie à semi-conducteurs (1) comprenant :
une section de pixel (100) qui comporte
un semi-conducteur transparent (4) formé dans une région de pixel effective (101) d'un isolateur (2), le semi-conducteur transparent (4) étant transparent dans une plage de lumière visible ;
un film de conversion photoélectrique organique (5) formé sur le semi-conducteur transparent (4) sur un côté opposé à l'isolateur (2), et
une électrode transparente (6) formée sur le film de conversion photoélectrique organique (5) sur un côté opposé au semi-conducteur transparent (4), l'électrode transparente (6) étant transparente dans la plage de lumière visible ;
une section de couplage (8) disposée dans l'isolateur (2) dans une région périphérique (102) autour de la région de pixels effective (101), la section de couplage (8) étant couplée à un circuit qui fournit de l'électricité à l'électrode transparente (6) ;
une ligne de câblage (63) qui couple électriquement l'électrode transparente (6) et la section de couplage (8) l'une à l'autre, et est formée d'un matériau d'électrode transparente, **caractérisé en ce que**
l'électrode transparente (6) comporte une première électrode transparente (61) formée sur le film de conversion photoélectrique organique (5), et une seconde électrode transparente (62) formée sur la première électrode transparente (61) sur un côté opposé au film de conversion photoélectrique organique (5), la ligne de câblage (63) étant formée dans une même couche électriquement conductrice qu'au moins une partie de l'électrode transparente (6).

2. Dispositif d'imagerie à semi-conducteurs (1) selon la revendication 1, dans lequel une épaisseur de la ligne de câblage (63) est plus mince qu'une épaisseur de l'électrode transparente (6).

3. Dispositif d'imagerie à semi-conducteurs (1) selon l'une quelconque des revendications précédentes, comprenant un isolateur de paroi latérale (7) sur une surface latérale du film de conversion photoélectrique organique (5) et sur une surface latérale du semi-conducteur transparent (4), dans lequel
la ligne de câblage (63) s'étend de l'électrode transparente (6) à la section de couplage (8) le long de la surface latérale du film de conversion photoélectrique organique (5) et de la surface latérale du semi-conducteur transparent (4), l'isolateur de paroi latérale (7) étant intercalé entre elles.

4. Dispositif d'imagerie à semi-conducteurs (1) selon l'une quelconque des revendications 1 à 3, dans lequel
la surface latérale du semi-conducteur transparent (4) est formée à l'intérieur de la surface latérale du film de conversion photoélectrique organique (5) dans la région de pixels effective (101), et
une cavité (4S) est formée entre la surface latérale du semi-conducteur transparent (4) et la ligne de câblage (63).

5. Dispositif d'imagerie à semi-conducteurs (1) selon l'une quelconque des revendications précédentes, dans lequel
un film protecteur (9) qui recouvre l'électrode transparente (6) et la ligne de câblage (63) est formé dans la région de pixels effective (101) et la région périphérique (102), et
un film bloquant la lumière (10) qui bloque la lumière est formé sur le film protecteur (9) sur un côté opposé à la ligne de câblage dans la région périphérique (102).

6. Dispositif d'imagerie à semi-conducteurs (1) selon la revendication 5, comprenant un isolateur de paroi latérale (7) sur une surface latérale du film de conversion photoélectrique organique (5) et sur une surface latérale du semi-conducteur transparent (4), dans lequel
la ligne de câblage (63) s'étend de l'électrode transparente (6) à la section de couplage (8) le long de la surface latérale du film de conversion photoélectrique organique (5) et de la surface latérale du semi-conducteur transparent (4), l'isolateur de paroi latérale (7) étant intercalé entre elles, et
l'isolateur de paroi latérale (7) s'étend entre l'isolateur (2) et le film protecteur (9) dans la région périphérique (102).

7. Dispositif d'imagerie à semi-conducteurs (1) selon la revendication 3 ou 6, dans lequel l'isolateur de paroi latérale (7) a une surface de paroi inclinée s'étendant de l'électrode transparente (6) au semi-conducteur transparent (4) et de la région de pixels effective (101) à la région périphérique (102).

8. Dispositif d'imagerie à semi-conducteurs (1) selon la revendication 7, dans lequel un angle d'inclinaison, sur un côté de la région de pixels effective (101), formé entre la surface de paroi inclinée et une surface de l'isolateur (2) est de 20 degrés ou plus et de moins de 90 degrés.

9. Dispositif d'imagerie à semi-conducteurs (1) selon la revendication 3 ou 6, dans lequel l'isolateur de paroi latérale (7) a une surface de paroi incurvée s'étendant de l'électrode transparente (6) vers le semi-conducteur transparent (4) et de la région de pixels effective (101) à la région périphérique (102), la surface de paroi incurvée faisant saillie de la région de pixels effective (101) à la région périphérique (102).

10. Dispositif d'imagerie à semi-conducteurs (1) selon la revendication 3 ou 6, dans lequel une épaisseur de l'isolateur de paroi latérale (7), formé sur la surface latérale du film de conversion photoélectrique organique (5), à partir de la surface latérale du film de conversion photoélectrique organique (5) est plus épaisse qu'une épaisseur de l'isolateur de paroi latérale (5), formé sur la surface latérale de l'électrode transparente (6), depuis la surface latérale de l'électrode transparente (6).

11. Dispositif d'imagerie à semi-conducteurs (1) selon l'une quelconque des revendications précédentes, dans lequel la ligne de câblage (63) est formée par un même matériau d'électrode transparente que l'électrode transparente (6) ou par un matériau d'électrode transparente différent de celui-ci.

12. Dispositif d'imagerie à semi-conducteurs (1) selon la revendication 5 ou 6, dans lequel le film de blocage de lumière (10) est un film ayant une contrainte plus faible que le film protecteur (9).
